Europäisches Patentamt

European Patent Office

Office européen des brevets

(19)

(11) **EP 1 230 736 B1**

(12) **FASCICULE DE BREVET EUROPEEN**

(45) Date de publication et mention
de la délivrance du brevet:
**28.05.2003 Bulletin 2003/22**

(51) Int Cl.⁷: **H03M 7/40**, H03M 13/41,
H03M 13/45, H03M 13/29

(21) Numéro de dépôt: **00974640.5**

(22) Date de dépôt: **02.11.2000**

(86) Numéro de dépôt international:
**PCT/FR00/03061**

(87) Numéro de publication internationale:
**WO 01/035535 (17.05.2001 Gazette 2001/20)**

(54) **PROCEDE DE DECODAGE DE DONNEES CODEES A L'AIDE D'UN CODE ENTROPIQUE, DISPOSITIF DE DECODAGE ET SYSTEME DE TRANSMISSION CORRESPONDANTS**

VERFAHREN ZUR DEKODIERUNG VON MIT EINEM ENTROPIE-CODE KODIERTEN DATEN, ENTSPRECHENDE DEKODIERUNGSVORRICHTUNG UND ÜBERTRAGUNGSSYSTEM

METHOD FOR DECODING DATA CODED WITH AN ENTROPIC CODE, CORRESPONDING DECODING DEVICE AND TRANSMISSION SYSTEM

(84) Etats contractants désignés:
**AT BE CH CY DE DK ES FI FR GB GR IE IT LI LU MC NL PT SE**

(30) Priorité: **09.11.1999 FR 9914321**
**13.04.2000 FR 0004787**

(43) Date de publication de la demande:
**14.08.2002 Bulletin 2002/33**

(73) Titulaires:
• **FRANCE TELECOM**
**75015 Paris (FR)**
• **TELEDIFFUSION DE FRANCE**
**75015 Paris (FR)**

(72) Inventeurs:
• **SIOHAN, Pierre**
**F-35200 Rennes (FR)**
• **CARLAC'H, Jean-Claude**
**F-35000 Rennes (FR)**
• **GUIVARCH, Lionel**
**F-35510 Cesson Sevigne (FR)**

(74) Mandataire: **Bioret, Ludovic**
**Cabinet Patrice Vidon,**
**Le Nobel (Bât. A),**
**Technopôle Atalante,**
**2, allée Antoine Becquerel,**
**BP 90333**
**35703 Rennes Cedex 07 (FR)**

• **GUIVARCH L ET AL: "Joint source-channel soft decoding of Huffman codes with turbo-codes" DATA COMPRESSION CONFERENCE, 28 - 30 mars 2000, pages 83-92, XP002143090 Snowbird, UT, USA**
• **BAUER R ET AL: "Iterative source/channel-decoding using reversible variable length codes" DATA COMPRESSION CONFERENCE, 28 - 30 mars 2000, pages 968-972, XP002154238 Snowbird, UT, USA cité dans la demande**
• **MURAD A H ET AL: "Joint source-channel decoding of variable-length encoded sources" INFORMATION THEORY WORKSHOP ITW98, 22 - 26 juin 1998, pages 94-95, XP002143123 Killarney, ireland cité dans la demande**
• **SUBBALAKSHMI K P ET AL: "Joint source-channel decoding of entropy coded Markov sources over binary symmetric channels" INTERNATIONAL CONFERENCE ON COMMUNICATIONS, vol. 1, 6 - 10 juin 1999, pages 446-450, XP002143232 Vancouver, BC, Canada cité dans la demande**
• **PARK M S ET AL: "Improved joint source-channel decoding for variable-length encoded data using soft decisions and MMSE estimation" PROCEEDINGS OF CONFERENCE ON DATA COMPRESSION (DCC'99), 29 - 31 mars 1999, page 544 XP002143145 Snowbird, UT, USA**

(56) Documents cités:

- **WEN J ET AL: "Utilizing soft information in decoding of variable length codes" PROCEEDINGS OF CONFERENCE ON DATA COMPRESSION (DCC'99), 29 - 31 mars 1999, pages 131-139, XP002143233 Snowbird, UT, USA cité dans la demande**

**Description**

Le domaine de l'invention est celui de la transmission, ou de la diffusion, de signaux de données numériques. Plus précisément, l'invention concerne le décodage de signaux numériques transmis, et en particulier le décodage de source. Plus précisément encore, l'invention s'applique au décodage de données codées à l'aide d'un codage de source mettant en oeuvre des codes entropiques de type codes à longueur variable (VLC, en anglais : « Variable Length Code »).

Les systèmes de communication numérique couramment utilisés aujourd'hui s'appuient sur des systèmes de codage mettant en oeuvre d'une part un codage de source et d'autre part un codage de canal. Classiquement, ces deux codages sont optimisés séparément. Le codeur de source a pour but de réduire au maximum la redondance du signal source à transmettre. Ensuite, pour protéger cette information des perturbations inhérentes à toute transmission, le codeur de canal introduit de la redondance, de manière contrôlée.

Actuellement, les meilleurs résultats sont obtenus en codage de source (source audio, images et/ou vidéo) par des codeurs par transformée en cosinus discrète (DCT, en anglais : "Discrete Cosine Transform") ou ondelettes notamment, associés à des codes VLC. Le codage de canal met en oeuvre avantageusement le concept des turbo-codes [1] (les références bibliographiques sont rassemblées en annexe C, afin de faciliter la lecture de la présente description), et plus généralement des décodeurs itératifs à décisions douces. Ces techniques ont permis de franchir un pas décisif vers la limite théorique définie par Shannon [2].

Toutefois, l'optimalité de la séparation du codage de source et du codage de canal n'est garantie que pour des codes de longueur tendant vers l'infini. De ce fait, des recherches sont également menées pour réaliser, avec des codes canal de longueur finie, des systèmes de codage et/ou de décodage conjoints source-canal.

L'invention concerne ainsi le décodage de codes entropiques, et en particulier, mais non exclusivement, le décodage conjoint source-canal d'un système mettant en oeuvre un code entropique.

Le décodage conjoint possède de nombreux champs d'application, par exemple la transmission d'images vidéo, en particulier selon la norme MPEG 4 (Moving Picture Expert Group).

Les codes à longueur variable sont bien connus. A titre d'exemple, on présente rapidement, en annexe A, le code de Huffman. Le mode de réalisation particulier de l'invention décrit par la suite s'applique notamment, mais non exclusivement, à ce type de code entropique.

Les codes à longueur variable présentent un enjeu important pour la limitation de la bande occupée par le signal émis, mais leur utilisation rend la transmission moins robuste aux erreurs. De plus, il est difficile d'utiliser les probabilités a priori de la source au décodage, car on ne connaît pas le début et la fin de chaque mot, puisque la longueur de ceux-ci est, par définition, variable.

Diverses techniques ont été proposées pour effectuer un décodage conjoint source-canal lié à l'utilisation de ces codes à longueur variable. Notamment :

- K. Sayood et N. Demir ont proposé dans [4] un décodage au niveau des mots de codes VLC. On retrouve les deux inconvénients majeurs de ce type de décodage, à savoir une complexité de treillis qui augmente rapidement avec le nombre de mots VLC différents et un décodage qui reste au niveau symbole (ou mot) ;
- Ahshun H. Murad et Thomas E. Fuja [5] proposent une méthode de super-treillis où le treillis de décodage est celui obtenu par le produit du treillis du décodeur de canal, du treillis du décodeur de source et du treillis représentant la source. Cette solution est clairement limitée par la complexité du décodage ;
- K.P. Subbalaskshmi et J. Vaisey [6] donnent une structure de treillis qui permet de connaître le début et la fin de chaque mot et donc d'utiliser l'information a priori que l'on a sur les mots VLC émis. Ce décodeur travaille au niveau des mots et ne renvoie pas d'information extrinsèque sur les bits décodés ;
- Jiangtao Wen et John D. Villasenor [7] utilisent un bloc de décodage travaillant au niveau des mots et renvoyant une fiabilité quant à la séquence décodée. Ce décodeur utilise comme information a priori le nombre de mots VLC dans la séquence reçue.

L'invention a notamment pour objectif de pallier les différents inconvénients de ces techniques de l'état de l'art.

Plus précisément, un objectif de l'invention est de fournir une technique de décodage de données codées à l'aide d'un code entropique permettant d'obtenir une réduction du taux d'erreur symbole, notamment par rapport à des schémas de décodage séparé (tandem).

Sur les aspects de mise en oeuvre, un objectif de l'invention est de fournir une telle technique de décodage présentant une complexité très réduite, par rapport aux techniques connues.

En particulier, un objectif de l'invention est de fournir une telle technique de décodage présentant une complexité opératoire raisonnable, c'est-à-dire possible à mettre en oeuvre en pratique à un coût raisonnable, en particulier lorsque le nombre de mots différents considérés par le code entropique est élevé.

L'invention a également pour objectif de fournir une telle technique délivrant des informations de confiance au niveau bit pouvant être exploitées par le décodage de canal.

En d'autres termes, un objectif particulier de l'invention est de fournir des procédés de décodage conjoints source-canal bien adaptés aux codes entropiques, notamment les codes VLC et RVLC.

Encore un autre objectif de l'invention est de fournir une telle technique de décodage, permettant d'améliorer les performances obtenues avec les codes de canal connus, et notamment les codeurs mettant en oeuvre un turbo-code.

Ces objectifs, ainsi que d'autres qui apparaîtront plus clairement par la suite, sont atteints à l'aide d'un procédé de décodage de données numériques reçues correspondant à des données numériques émises codées à l'aide d'un code entropique associant à chacun des mots d'un alphabet une séquence de bits distincte, dont la longueur est fonction de la probabilité d'occurrence dudit mot.

Selon l'invention, ce procédé met en oeuvre un treillis de décodage dont chaque transition correspond à une valeur binaire 0 ou 1 d'un des bits d'une séquence de bits correspondant à l'un desdits mots.

En d'autres termes, l'invention repose sur une approche nouvelle du décodage des codes à longueurs variables, selon laquelle on considère les transitions au niveau des bits, et non classiquement au niveau des mots, ou symboles.

Cette approche est nouvelle, et non évidente, l'homme du métier étant persuadé que le fait que les symboles sont de longueurs variables imposent de travailler au niveau des symboles, afin de connaître le début et la fin de ceux-ci. Les inventeurs montre que cela n'est pas obligatoire.

De plus, le fait de travailler au niveau des bits permet d'obtenir une information exploitable par un décodeur canal, et donc d'effectuer un décodage conjoint, comme cela apparaîtra plus clairement par la suite.

Ledit code entropique peut être représenté sous la forme d'un arbre binaire comprenant un noeud racine, une pluralité de noeuds intermédiaires et une pluralité de noeuds feuilles, une séquence de bits correspondant à un desdits mots étant formée en considérant les transitions successives dudit arbre depuis ledit noeud racine jusqu'au noeud feuille associé audit mot. Dans ce cas, de façon avantageuse, les états de chaque étage dudit treillis comprennent un unique état dit extrémal, correspondant audit noeud racine et à l'ensemble desdits noeuds feuilles, et un état distinct, dit état intermédiaire pour chacun desdits noeuds intermédiaires.

On obtient ainsi un treillis simple, à nombre d'états réduit.

De façon préférentielle, on associe à chaque transition dudit treillis une information de vraisemblance. Ladite information de vraisemblance est alors avantageusement une métrique tenant compte d'une part d'une information représentative du canal de transmission et d'autre part d'une information a priori sur ledit code entropique.

Par exemple, ladite information a priori appartient au groupe comprenant :

- le code entropique mis en oeuvre ; et /ou
- les probabilités a priori de chacun desdits mots du code ; et/ou
- le nombre de mots émis ; et/ou
- des valeurs limites pour les coefficients.

Ainsi, on peut calculer, pour chacune desdites transitions, la probabilité suivante :

$$\Gamma_i[(x_k, x_k^p), d_k, d_{k-1}] = \Pr(x_k/a_k = i)\Pr(y_k^p/a_k = i, d_k, d_{k-1})\Pr\{a_k = i, d_k/d_{k-1}\}$$

dont les informations et paramètres sont décrits par la suite.

Ledit code entropique peut notamment appartenir au groupe comprenant :

- les codes de Huffinan ;
- les codes à longueur variable réversibles (RVLC).

Préférentiellement, dans le cas d'un code RVLC, ladite information a priori est utilisée pour une phase aller de parcours dudit treillis et une phase retour de parcours dudit treillis.

L'invention concerne également un procédé de décodage conjoint source-canal d'un signal numérique reçu, basé sur cette approche, le codage source mettant en oeuvre un code entropique associant à chacun des mots d'un alphabet une séquence de bits distincte, dont la longueur est fonction de la probabilité d'occurrence dudit mot.

Selon l'invention, ce procédé de décodage conjoint met donc en oeuvre un décodage source utilisant au moins un treillis de décodage dont chaque transition correspond à une valeur binaire 0 ou 1 d'un des bits de la séquence de bits correspondant à l'un desdits mots, ledit décodage source délivrant une information extrinsèque au décodage canal.

Le décodage canal peut avantageusement mettre en oeuvre un décodage de type turbo-code, pouvant reposer sur une mise en oeuvre de type parallèle ou sur une approche de type série.

De façon avantageuse, le procédé de décodage conjoint de l'invention repose sur une mise en oeuvre itérative.

Dans ce cas, chacune des itérations peut comprendre séquentiellement une étape de décodage canal et une étape de décodage source, ladite étape de décodage canal délivrant une information de canal prise en compte dans ladite étape de décodage source, cette dernière délivrant une information a priori prise en compte dans ladite étape de décodage canal.

Notamment, le procédé peut comprendre :

- une première étape de décodage canal ;
- une première étape de décodage source, alimentée par ladite première étape de décodage canal ;
- une seconde étape de décodage canal, alimentée par ladite première étape de décodage canal et ladite première étape de décodage source, via un entrelaceur identique à l'entrelaceur mis en oeuvre au codage, et alimentant ladite première étape de décodage canal, via un désentrelaceur symétrique audit entrelaceur ;
- une seconde étape de décodage source alimentée par ladite seconde étape de décodage canal via ledit désentrelaceur, et alimentant ladite première étape de décodage canal.

Selon un autre aspect de l'invention, celle-ci concerne encore un procédé de décodage conjoint source-canal d'un signal numérique reçu, le codage source mettant en oeuvre un code entropique associant à chacun des mots d'un alphabet une séquence de bits distincte, dont la longueur est fonction de la probabilité d'occurrence dudit mot, ledit procédé mettant en oeuvre un treillis de décodage canal, similaire au treillis de codage canal, dans lequel on associe à chaque état de chaque étage une information représentative d'une séquence, passant par cet état, de bits décodés du passé, par rapport au sens de parcours dudit treillis, désignant la position du bit considéré dans l'arbre représentant ledit code entropique et/ou une information de vérification du nombre de mots décodés et/ou de la valeur prise par lesdits bits décodés.

Dans ce cas, le procédé de décodage conjoint comprend avantageusement, pour chacun desdits états, les étapes suivantes :

- ajout, aux deux branches arrivant dans ledit état, de la métrique du canal et de la métrique de la source ;
- comparaison des deux nouvelles métriques obtenues, et sélection de la métrique la plus faible ;
- si ladite information désignant la position indique la fin d'un mot, considérer que le noeud est une feuille de l'arbre, sinon, passer au noeud suivant dans l'arbre.

Préférentiellement, ce procédé met en oeuvre une procédure itérative, qui peut par exemple comprendre les étapes suivantes :

- premier décodage canal, mettant en oeuvre un treillis de décodage canal dont chaque état dispose d'une information désignant la position du bit considéré dans l'arbre représentant ledit code entropique ;
- deuxième décodage canal, alimenté par ledit premier décodage canal, via un entrelaceur identique à celui mis en oeuvre au codage, et alimentant ledit premier décodage canal, via un désentrelaceur symétrique dudit entrelaceur ;
- décodage source, alimenté par ledit deuxième décodage canal, via ledit désentrelaceur.

A nouveau, dans ce cas, on met avantageusement en oeuvre un décodage de type turbo-code (parallèle ou série).

Avantageusement, chaque itération dudit décodage de type turbo-code met en oeuvre une matrice en bloc, présentant des lignes et des colonnes, sur laquelle est effectuée un décodage des lignes (respectivement colonnes) suivi d'un décodage des colonnes (respectivement lignes), et on utilise ladite information a priori pour ledit décodage des lignes (respectivement colonnes).

Dans ce cas, préférentiellement, chaque ligne (respectivement colonne) correspond à un mot de code, formé de $k$ bits d'information et de $n\text{-}k$ bits de bourrage, et en ce que ladite information a priori est utilisée sur lesdits $k$ bits d'information.

En particulier lorsque le code utilisé est un code RVLC, il est avantageux de concaténer les treillis de décodage canal et de décodage source, ledit décodage de canal étant contrôlé par une information a priori sur la source.

On peut alors mettre en oeuvre un algorithme dit "List-Viterbi", de type parallèle ou de type série, associé à une étape de remplacement d'une séquence non-autorisée par la source, par la séquence autorisée la plus probable, lors du parcours du treillis du décodage de canal ou un algorithme dit "SUBMAP", dans les sens de parcours aller et retour du treillis de décodage de canal.

Préférentiellement, le procédé de décodage met également en oeuvre une étape de détection de la fin de la séquence de mots de code à décoder.

Cette étape de détection peut notamment reposer sur la mise en oeuvre d'au moins une des techniques appartenant au groupe comprenant :

- insertion à l'émission d'une information de fin de séquence ;
- insertion de bits de bourrage, de façon que le treillis du décodeur de canal associé à la séquence émise se termine dans un état connu ;
- utilisation de la technique dite "tail-biting" ;
- utilisation d'un treillis circulaire.

De façon avantageuse, dans les différents modes de réalisation abordés ci-dessus, le procédé comprend en outre une étape de recherche de la séquence autorisée la plus probable, à l'aide d'un treillis symbole réduit, présentant un état de départ unique (d0) duquel partent et arrivent autant de mots qu'il existe de mots de code.

Bien entendu, l'invention concerne également tous les dispositifs de décodage de données numériques mettant en oeuvre l'un des procédés de décodage décrits ci-dessus, ainsi que les systèmes de transmission d'un signal numérique, mettant en oeuvre, à l'émission, un codage source entropique et un codage canal, et à la réception, un décodage tel que décrit plus haut.

D'autres caractéristiques et avantages de l'invention apparaîtront à la lecture de la description suivante de modes de réalisation préférentiels de l'invention, donnés à titre de simple exemple illustratif et non limitatif, et des dessins annexés, parmi lesquels :

- la figure 1 présente un exemple d'un code de Huffman, sous la forme d'un arbre binaire ;
- la figure 2 illustre un treillis symbole dit réduit, correspondant à l'arbre de la figure 1 ;
- la figure 3 présente un treillis binaire dit réduit selon l'invention, correspondant à l'arbre de la figure 1 ;
- la figure 4 est un schéma illustrant une structure de décodage conjoint de type turbo-code, mettant en oeuvre un module "SISO_huff" selon l'invention ;
- la figure 5 illustre le déroulement de l'algorithme de décodage conjoint source-canal selon un second mode de mise en oeuvre ;
- la figure 6 présente un schéma itératif de décodage conjoint mettant en oeuvre l'algorithme illustré en figure 5 ;
- la figure 7 présente une combinaison des procédés des figures 4 et 6;
- la figure 8, commentée en annexe A, illustre la construction d'un codage de Huffman.
- la figure 9 présente 9 présente la matrice du turbo-décodage en blocs de code de Huffman ;
- la figure 10 illustre un décodage conjoint de codes RVLC ;
- les figures 11 et 12 présentent deux modes de mise en oeuvre d'un décodage conjoint des codes RVLC avec des turbo-codes, avec utilisation d'un treillis réduit.

### *Modes de réalisation préférentiels*

### **1-Introduction**

L'invention a donc notamment pour objectif de présenter une technique de décodage réduisant le taux d'erreurs symboles, en utilisant les informations a priori sur la source, probabilités sur les mots du code VLC ou probabilités de transition entre les mots. On a constaté que cette réduction est plus élevée si les décodeurs utilisent les informations a priori sur la source au niveau bit, car l'extraction d'informations du décodage de canal ne peut se faire qu'à ce niveau bit.

Jusqu'à présent, la plupart des méthodes proposées pour le décodage des codes VLC travaillent au niveau des mots (ou symboles, ces deux termes étant utilisés indifféremment par la suite) et ne peuvent donc pas fournir d'informations extrinsèques au niveau bit. De plus, ces méthodes deviennent pour la plupart trop complexes, et donc non réalisables en pratique, lorsque le nombre de mots différents à transmettre augmente. La seule tentative faite au niveau bit est présentée dans [5]. Très clairement, cette solution présente une complexité opératoire très élevée, et rapidement rédhibitoire.

La technique de l'invention permet en revanche de déterminer non seulement la séquence de mots optimale, mais également la fiabilité associée à chacun des bits de chaque mot. Pour ce faire, l'invention utilise une information a priori sur la source, c'est-à-dire la probabilité a priori des mots du code VLC, ou celle de transition de Markov entre les mots du code.

Cette technique peut avantageusement être utilisée dans un schéma itératif de type turbo-code, et améliore les performances de la transmission.

**2- Notation**

On utilise notamment par la suite les notations suivantes :

- une décision douce correspond à une décision réelle non binaire. Un seuillage sur celle-ci donnera une décision dure. Une décision douce est aussi appelée décision « soft » ;
- le rapport $E_b/N_O$ correspond au rapport entre l'énergie reçue par bit utile divisée par la densité spectrale monolatérale du bruit ;
- la bande DC (Direct Component) d'une image est la composante continue de l'image après transformation par ondelette ou par DCT ;
- une séquence de bit reçus est notée par $X$ ou $Y$. Cette séquence se compose de mots notés $x^i$, ces mots étant composés de bits notés $x^i_j$;
- on utilise la notation $p(a) = Pr\{x^i = a\}$
- un code RVLC (en anglais : « Reversible VLC ») [8] est un code à longueur variable dont les mots se décodent dans les deux sens ;
- un algorithme SISO (« Soft-In Soft-Out ») a pour entrées des valeurs « soft » et délivre des sorties « soft ».

**3- Décodage "soft " source de codes à longueur variable**

On montre, en annexe B, comment il est possible d'extraire de l'information des suites de mots de longueur variable émise par un codeur de Huffman (voir annexe A), en modélisant la source, soit par un processus aléatoire générant des symboles indépendants, soit par un processus aléatoire markovien.

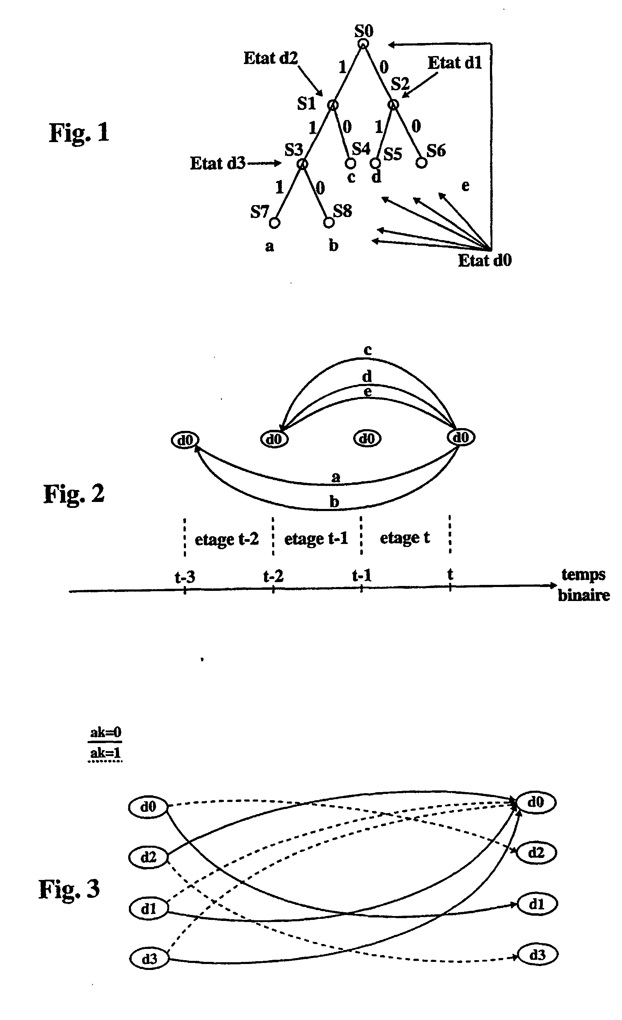

La figure 1 présente l'exemple d'un code de Huffman, sous la forme d'un arbre binaire. Il est composé de cinq mots $a, b, c, d, e$ de probabilités $p(a), p(b), p(c), p(d)$, et $p(e)$, et de longueurs respectivement 3, 3, 2, 2 et 2.

La table de codage correspondante est donnée ci-dessous :

Table 1 :

| table des codes VLC de l'arbre de la figure 1. | |
|---|---|
| $a$ | 111 |
| $b$ | 110 |
| $c$ | 10 |
| $d$ | 01 |
| $e$ | 00 |

En se plaçant, selon l'approche de l'invention, au niveau bit, on observe que quatre états sont nécessaires pour décrire sous forme de treillis, l'arbre de la figure 1. Ces états sont $d0$ pour le début et la fin des symboles, $d1$, $d2$ et $d3$ pour les positions intermédiaires. Par contre, au niveau symbole, on remarque qu'un seul état $d0$ peut suffire, ainsi que l'illustre la figure 2. Le treillis symbole réduit ainsi défini est donc alors un treillis à un seul état d0, duquel partent et arrivent autant de branches qu'il existe de mots VLC. Dans l'exemple de la figure 1, à chaque étage (t-2, t-1, t), ce treillis présente cinq branches correspondant aux mots $a, b, c, d$ et $e$.

Le treillis symbole réduit utilise les probabilités a priori sur les mots de la source, en travaillant au niveau des mots. Ce treillis peut également être utilisé comme treillis annexe lors du décodage utilisant les probabilités de Markov. Comme on le verra par la suite, ce treillis réduit peut avantageusement être mis en oeuvre en complément du décodage de l'invention.

**4- Décodage selon l'invention, au niveau des bits**

On a vu que, selon les techniques connues, les procédés de décodage d'une source VLC utilisent les probabilités a priori des mots VLC au niveau des mots, ce qui empêche de renvoyer la fiabilité sur chaque bit de la séquence décodée. On montre par la suite comment les probabilités a priori sur les mots peuvent être décomposées en un produit de probabilité a priori sur les bits, puis on décrit les procédés de décodage s'appuyant sur cette approche.

*4.1 Utilisation des probabilités a priori des mots de codes VLC au niveau des bits*

Cette partie explique la décomposition des probabilités des mots en un produit de probabilités binaires.

Prenons l'exemple du mot *a* : On a d'après l'arbre de la figure 1 :

$$p(a) = Pr\{x^i = a\} = Pr\{x_0^i = 1, x_1^i = 1, x_2^i = 1\} \tag{8}$$

Cette probabilité se décompose suivant l'équation :

$$p(a) = Pr\{x_0^i = 1\}Pr\{x_1^i = 1/x_0^i = 1\}Pr\{x_2^i = 1/x_0^i = 1, x_1^i = 1\} \tag{9}$$

La probabilité *p(a)* est donc le produit de trois probabilités associées à chacun des bits du mot *a*.
Avec un treillis qui indique la position du bit dans le mot que l'on décode, ces probabilités binaires permettent de faire du décodage « soft » binaire.

$$Pr(x_1^i = 1/x_0^i = 1)$$

Par exemple, si on sait que l'on est dans la deuxième position du mot *a* alors la probabilité à utiliser sur la branche est .

$$Pr\left\{x_k^i = +1/(x_j^i = +1, j < k)\right\}$$

Calculons, pour le mot *a* et pour *k* = 0,1,2 les probabilités pour le mot *a*.

$$Pr\{x_0^i = 1\} = Pr\{sommet_{i,0} = S1\} = p(a) + p(b) + p(c) \tag{10}$$

L'arbre de la figure 1 donne immédiatement la solution. On en déduit, aux différents sommets de l'arbre, les égalités :

$$Pr\{x_1^i = 1/x_0^i = 1\} = Pr\{sommet_{i,1} = S3/sommet_{i,0} = S1\}$$

$$= \frac{p(a) + p(b)}{p(a) + p(b) + p(c)} \tag{11}$$

$$Pr\{x_2^i = 1/x_0^i = 1, x_1^i = 1\} = Pr\{sommet_{i,2} = S7/sommet_{i,1} = S3\}$$

$$= \frac{p(a)}{p(a) + p(b)} \tag{12}$$

Ce calcul peut se généraliser facilement au cas d'un code de Huffman réel. Soit *C*=(*w^i*) l'ensemble des mots de code Huffman,

$$S_k = \left\{n \in N \middle| \forall p < k, w_p^n = x_p^i\right\}$$

l'ensemble des index des mots dont les *k* premiers bits sont égaux aux *k* premiers bits du mot *x^i* et

$$S_k^s = \{n \ \varepsilon \ S | w_k^0 = s\}$$

les index de $S_k$ des mots dont le *k^{ième}* bit est égal à *s* (*s* ε {0,1}), on a :

$$Pr\{x_k^i = S | x_{p(p<k)}^i\} = \frac{\Sigma_{l \varepsilon S_t}^{z} Pr(w^l)}{\Sigma_{l \varepsilon S_k} Pr(wl)} \qquad (13)$$

Ce principe de calcul est illustré ici dans le cas d'une source de mots indépendants. Pour une source de Markov, le principe est le même sauf que chaque distribution des probabilités calculée dépend du mot précédent trouvé. Ainsi, le calcul est à faire pour tous les mots précédents possibles.

Une fois cette décomposition faite pour tous les mots du code VLC, il faut trouver le treillis binaire réduit qui permette d'utiliser les probabilités binaires. La décomposition de $p(a)$, $p(b)$,... en un produit de probabilités binaires a imposé une certaine relation entre les probabilités binaires et les probabilités de mots. Ces relations sont conservées uniquement s'il y a une bijection entre les branches de l'arbre et celles du treillis. Il faut donc le treillis le moins complexe possible qui donne la position des bits dans chaque mot et qui évite les branches parallèles identiques (même état de départ, même état d'arrivée et même étiquette). Premièrement, nous allons décrire l'algorithme de construction du treillis binaire réduit. Puis nous donnerons l'algorithme de décodage sur ce treillis et notamment l'utilisation des probabilités binaires a priori.

*4.2.1 Algorithme de construction du treillis binaire réduit*

*Initialisation du treillis*

Premier état du treillis, état 0 : origine de l'arbre
    i = 1
    *boucle de construction*

{

Pour chaque mot de la table VLC,

Pour chaque bit de ce mot,

   *construction des états*

   Si l'état de départ de la branche de l'arbre étiquetée par ce

   bit n'est pas associé à un état du treillis, ajouter un état au

   treillis, état *i*

i++

   Si l'état d'arrivée de la branche n'est pas associé à un état

   du treillis,

Si il correspond à un nœud non terminal de l'arbre,

Ajouter un état au treillis, état *j (j==i)*

i++

Sinon associer cet état à l'état *j (j = 0)*

   *étiquetage des branches*

   Créer, si non existante, une branche entre l'état *i* et l'état *j*

étiquetée par le bit traité

}

Dans le cas de notre exemple, on obtient ainsi le treillis de la figure 3.

Ce treillis donne la position du bit dans le mot. Si on est dans l'état *i*, on sait, à partir de l'arbre, que l'on est dans la position *j* du mot traité car il existe une correspondance bijective entre les états *i* du treillis et les positions *j* dans l'arbre.

*4.2.2 Algorithme de décodage à partir du treillis binaire réduit*

L'algorithme de décodage utilisé sur ce treillis pour les simulations données par la suite est un algorithme de type BCJR (Bahl Cocke Jelinek Raviv) [13] modifié par Benedetto dans [14] pour traiter les branches parallèles.

La métrique calculée sur chaque branche tient compte de la connaissance que l'on a sur le canal et des probabilités a priori binaire calculées précédemment. Plus précisément, la formule de calcul sur une branche [15] est :

$$\Gamma_i[(x_k, x_k^p), d_k, d_{k-1}] = \Pr(x_k/a_k = i)\Pr(y_k^p/a_k = i, d_k, d_{k-1})\Pr\{a_k = i, d_k/d_{k-1}\} \tag{14}$$

A l'instant discret k, le couple $(x_k, x_k^p)$ est le couple de vraisemblances des bits reçus, $d_{k-1}$ et $d_k$ sont respectivement les états de départ et d'arrivée de la branche, $a_k$ est le bit d'information associé à la branche.

Les deux premiers termes de droite de l'équation (14) font référence à la connaissance que l'on a sur le canal. Le troisième, $\Pr\{a_k = i, d_k d_{k-1}\}$ correspond à la probabilité binaire a priori.

Plus généralement, cette information a priori sur la source peut être de plusieurs types :

- soit elle correspond à la connaissance de la table du code de Huffman, réversible (RVLC) ou non. Dans ce cas, l'information a priori consiste en des probabilités appartenant à l'ensemble $\{0, 1, 0.5\}$ .
- soit elle correspond à la connaissance de la table du code de Huffman, réversible ou non, et des probabilités des mots associés. Dans ce cas, elle consiste en des probabilités appartenant au segment [0,1] ;
- soit elle correspond à la connaissance du nombre de mots émis, du nombre de bits, ou des valeurs limites que peuvent prendre les coefficients.

Ce treillis est utilisable dans un décodage soft binaire de type BCJR ou de type SOVA (en anglais : "Soft Output Viterbi Algorithm"). Lors de l'utilisation des probabilités a priori de Markov, si on utilise l'algorithme BCJR, le décodage soft nécessite un traitement parallèle qui indique pour chaque étage le mot précédent le plus probable. Ce traitement est celui réalisé par le treillis symbole réduit. Cette augmentation de complexité implique une préférence pour l'algorithme SOVA ou pour l'algorithme SUBMAP [11].

*4.3 Généralisations*

La méthode présentée se généralise sans difficulté aux cas où la table de Huffman contient plus de bits. Cependant la complexité du treillis binaire réduit augmente avec le nombre de mots de la table de Huffman.

L'application de la méthode de l'invention aux codes RVLC [8] peut bien sûr être envisagée. Le treillis du bloc « SISO_huff» peut être utilisé en décodant dans l'autre sens mais cela implique une augmentation de la complexité. Une alternative serait d'utiliser les probabilités a priori dans un sens pour la phase « forward » et dans l'autre pour la phase « backward ».

D'autre part, il est intéressant de chercher parmi les codes de Huffman équivalents [17], celui qui est le mieux adapté pour le décodage « soft » du bloc « SISO_huff ».

**5- Décodage conjoint source-canal**

*5.1 Schéma de principe d'utilisation du bloc "SISO_huff"*

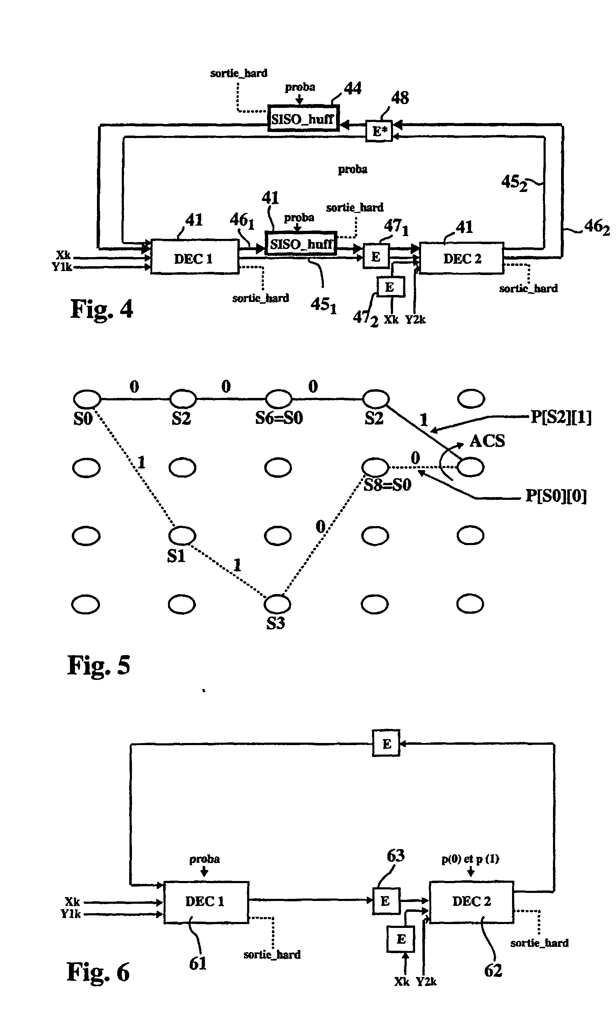

Le treillis binaire réduit ou "SISO_huff" permet un décodage de type SISO et peut donc s'insérer dans un schéma de décodage itératif comme celui de la figure 4.

Chaque bloc de décodage 41 à 44 de la figure 4 extrait de l'information extrinsèque sur les bits à décoder et envoie cette information au bloc suivant. Les informations qui circulent entre les différents blocs sont, comme dans la référence [15] des probabilités extrinsèques.

Des deux décodeurs de canal DEC1 et DEC2, 41 et 43, on extrait deux informations extrinsèques différentes suivant qu'elles sont utilisées par le bloc "SISO_huff" 42 ou 44 ou par l'autre décodeur de canal 41 ou 43. L'information extrinsèque $45_1$, $45_2$ utilisée par le décodeur de canal suivant est celle classiquement utilisée dans les turbo-codes. Celle utilisée par le bloc "SISO_huff" 42, 44, représentée en gras, $46_1$, $46_2$ correspond à cette première information à laquelle on a enlevé l'information issue du précédent bloc "SISO_huff", 44, 42, ceci dans le but de respecter la règle selon laquelle tout bloc du décodage itératif ne doit pas utiliser une information qu'il a déjà produite.

La structure globale du décodeur itératif n'est pas discutée plus en détail. Elle est en effet connue en soi [1]. Les modules E $47_1$ et $47_2$ sont des entrelaceurs (identiques à ceux mis en oeuvre au codage) et le module E* 48 un désentrelaceur, symétrique à l'entrelaceur.

Les informations prises en compte sont les suivantes :

- $X_k$: Information de vraisemblance reçue sur les bits d'information émis ;
- $Y_{1k}$ : Information de vraisemblance sur les bits de parité issus du codeur 1 ;
- $Y_{2k}$ : Information de vraisemblance sur les bits de parité issus du codeur 2 ;
- Proba : probabilité a priori ;
- Sortie_hard : bit d'information décodé.

Ce schéma est un exemple de décodage conjoint itératif où l'information a priori et l'information du canal sont utilisées tour à tour sur leur treillis associé. Il est aussi envisageable d'utiliser conjointement ces deux informations sur le treillis du décodeur canal comme le montre le deuxième procédé proposé.

### 5.2 Second algorithme de décodage conjoint source-canal

Le décodage conjoint proposé à la figure 4 réalise itérativement et séquentiellement les deux fonctions de décodage. On présente ci-après une technique où un bloc unique de décodage réalise simultanément les deux opérations. Cette technique s'applique aussi au décodage d'une source markovienne.

Le concept développé est applicable à toute chaîne de transmission composée d'un treillis de décodeur de canal (convolutif ou en bloc) et d'une source représentable par un arbre.

### 5.2.1 Algorithme de construction du treillis

Le treillis utilisé est celui du codeur de canal et ne nécessite aucune nouvelle construction.

### 5.2.2 Algorithme de décodage

L'algorithme de décodage est de type Viterbi. Il décode la séquence de mots la plus probable. Le calcul de métrique fait intervenir non seulement l'information du canal (cas usuel) mais aussi les probabilités a priori binaires.

Plus généralement, on associe à chaque état de chaque étage une information dépendant de la séquence (passant par cet état) des bits décodés du passé par rapport au sens de parcours du treillis. Cette information peut notamment désigner la position du bit considéré dans l'arbre représentant ledit code entropique. Elle peut aussi être, par exemple, une vérification du nombre de mots décodés ou de la prise par les coefficients décodés.

Cette méthode s'apparente à celle présentée par Hagenauer [15] mais appliquée ici aux codes à longueur variable.

Pour ceci, l'algorithme doit savoir à quelle branche de l'arbre de Huffman correspond la branche actuellement traitée sur le décodeur de canal. Cette information lui suffit pour donner la probabilité a priori binaire adéquate (calculée comme dans le paragraphe 4.1 et stockée au préalable dans un tableau).

Cette information est facilement accessible en tenant à jour pour chaque étage et pour chaque état du treillis du décodeur de canal la position du bit dans l'arbre.

Pour chaque étage du décodeur de canal,

Pour chaque état,

{

*corps de l'ACS (Add Compare Select)*

ajouter aux deux branches arrivant dans l'état la métrique du canal

et celle de la source

comparer les deux nouvelles métriques obtenues, choisir celle de

métrique la plus faible *remise à jour*

si on atteint la fin d'un mot,

nœud = racine de l'arbre

sinon

nœud = nœud suivant dans l'arbre

}

Reprenons l'exemple de l'arbre de la figure 1. L'algorithme se déroule comme présenté sur la figure 5. A l'étage considéré, il y a deux séquences concurrentes arrivant au deuxième état du treillis. Chacune correspond à un enchaînement de mots VLC différents. La première, en trait plein, correspond à l'émission de *e, d*,..., la seconde, en trait pointillé à *b, e*,.....La probabilité de branche a priori pour chacune d'elle, *P* [S2][0] et *P* [S0][1], dépend du noeud *Si* noté sur la séquence et du bit 0 ou 1 qui étiquette la branche. Une fois le calcul de la probabilité de la branche effectué, par la relation (6), on peut faire l'ACS classique.

Cette solution est très intéressante car, contrairement à la solution du bloc "SISO_huff", elle n'est pas limitée en complexité par la taille de la table de Huffman et n'augmente que de très peu la complexité actuelle des décodeurs de canal.

## 6- Application du second algorithme à un schéma itératif de décodage conjoint

### 6.1 Utilisation de cette méthode dans un schéma itératif

Un schéma pour l'utilisation dans un décodage itératif est représenté sur la figure 6.

Le premier décodeur 61 utilise sur le même treillis l'information du canal et l'information a priori. Par contre, le deuxième décodeur 62 ne peut pas utiliser l'information a priori car l'entrelaceur 63, noté *E,* casse les relations entre les mots de code VLC. Ce dernier utilise alors les probabilités *p*(0) et *p*(1) qui sont dans la plupart des cas différentes.

### 6.2 Cumul des deux approches de décodage conjoint

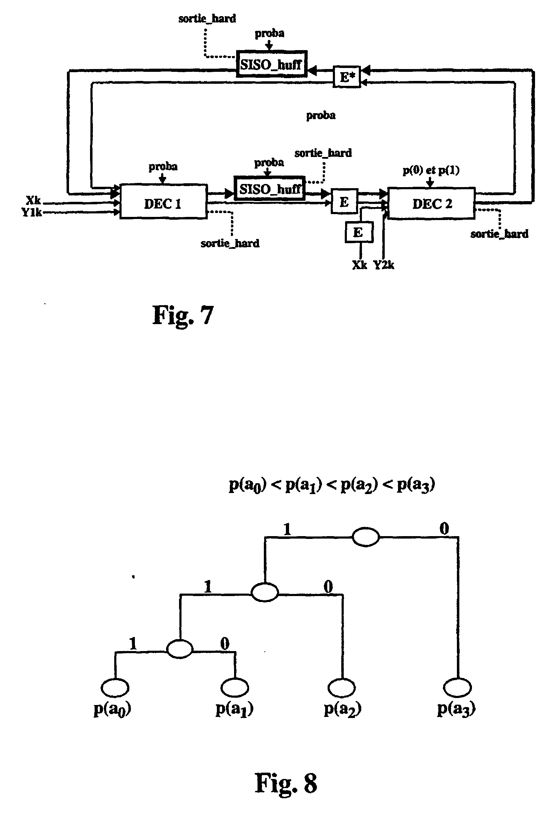

Il est possible d'utiliser les deux procédés proposés ci-dessus dans un schéma itératif, tel que celui donné à titre d'exemple en figure 7. Sur cette figure, les notations sont identiques à celles utilisées précédemment.

L'élaboration d'un entrelaceur conservant les relations entre les mots permet de trouver un compromis entre entrelacement binaire optimal et conservation de la structure a priori sur les mots.

## 7-Cas des turbo-codes en blocs

Chaque itération des turbo-codes en blocs comprend un décodage "soft" (à décisions pondérées) des lignes puis un décodage "soft" des colonnes (ou inversement). La méthode décrite par la suite s'utilise de la même façon, que l'on utilise l'information a priori sur un décodage ligne ou sur un décodage colonne. Il faut noter que de même que, pour les Turbo-Codes convolutifs, l'information a priori ne peut-être utilisé que dans un sens (ligne ou colonne) car l'entrelaceur casse l'ordre des bits pour l'autre sens.

Chaque ligne (ou colonne) de la matrice en bloc correspond à un mot de code. Pour un code de rendement *k*/*n*, un mot de code contient *k* bits d'information et *n - k* bits de redondance.

En notant l'ensemble des *k* premiers bits *K* et celui des *n -k* bits de parité M, l'équation de la probabilité a priori d'un mot de code *C* devient

$$P(C) = P(K,M)$$

$$= P(K) \times P(M/K)$$

$$= P(K)$$

L'information a priori est donc utilisée sur les *k* premiers bits de chaque mot de code.

On en déduit que la probabilité d'un mot est donnée par

- si les mots émis par la source sont indépendants :

$$P(C) = \prod_i \prod_j p \ (x^i_j / x^i_{k(k<j)}).$$

- si les mots émis suivent un processus de Markov d'ordre 1, comme par exemple dans le cas d'un codeur d'image en sous-bandes pour ce qui concerne la composante continue :

$$P(C) = \prod_i \prod_j p \ (x^i_j / x^i_{k(k<j)}, x^{i-1})$$

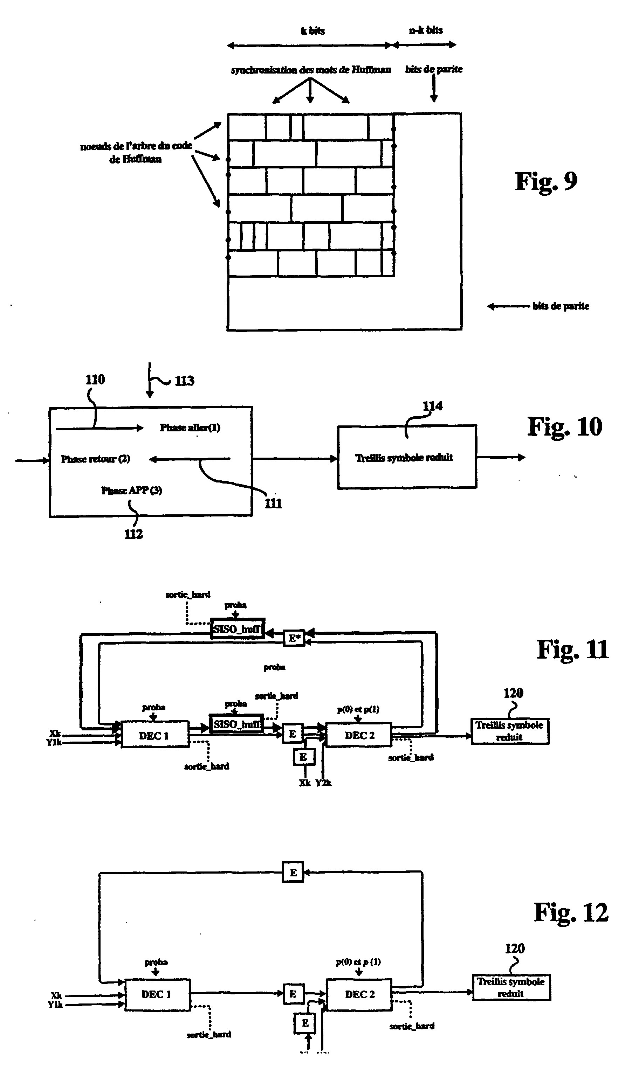

A la fin de chaque groupe de k bits, on doit garder en mémoire le noeud de l'arbre du code de Huffman auquel on est arrivé pour l'utiliser pour le décodage du groupe de k bits suivant comme l'illustre la figure 9. Pour être sûr du noeud duquel on part à chaque début de mot de code, on peut envoyer cette information, mais cela réduit d'autant la compression.

Il faut noter que le schéma général de décodage des Turbo-Codes est le même que l'on utilise les Turbo-Codes en blos ou convolutifs. La différence réside dans l'entrelaceur et dans chacun des deux décodeurs DEC1 et DEC2.

### 8- Cas des codes RVLC

On décrit ci-après une variante de l'invention, mettant en oeuvre un procédé de décodage de codes RVLC utilisant une information a priori sur la source.

Une particularité de ce procédé est l'utilisation des informations a priori sur la source pendant les phases aller et retour de parcours du treillis grâce à la propriété de décodage dans les deux sens des codes RVLC.

### 8.1- Etat de l'art du décodage RVLC

Pour accroître la robustesse des codes à longueur variable, les codes RVLC [8] ont été proposés.

Les codes RVLC sont une extension des codes de Huffman. Ils vérifient la condition dite du préfixe dans les deux sens. Ainsi, que l'on prenne une séquence de mots RVLC dans un sens ou dans l'autre, cette séquence binaire ne peut jamais être à la fois représentative d'un élément codé et constituer le début du code d'un autre élément. Cette double propriété fait perdre au niveau compression et impose des contraintes lors de la fabrication d'un code de Huffman. Il est à noter que les codes RVLC peuvent être symétriques ou asymétriques.

L'exemple ci-dessous montre le cas d'un code RVLC symétrique à 4 mots.

| mot | proba | codage |
|-----|-------|--------|
| $a_0$ | $p(a_0)$ | 010 |

(suite)

| mot | proba | codage |
|---|---|---|
| $a_1$ | $p(a_1)$ | 101 |
| $a_2$ | $p(a_2)$ | 11 |
| $a_3$ | $p(a_3)$ | 00 |

Par ailleurs, quelques méthodes de décodage de ces codes ont déjà été décrites :

- R. Bauer et J. Hagenauer [20] proposent un décodage souple itératif liant le décodeur de canal et le décodeur de source, qui est un treillis utilisé au niveau bit représentant le code RVLC.
- J. Wien et J. Villasenor [21] donnent un moyen simple d'utiliser les propriétés de réversibilité des codes RVLC en travaillant sur des valeurs dures des bits.

**8.2-Etat de l'art du décodage des VLC avec l'algorithme ListViterbi**

L'utilisation de l'algorithme List-Viterbi permet de classer et de garder en mémoire les séquences dans l'ordre de probabilité d'occurrence. Ce stockage permet l'utilisation de certaines séquences lorsque la séquence la plus probable ne vérifie pas une condition a priori.
Cet algorithme a été utilisé par Murad et Fuja pour le décodage des codes VLC lorsque le décodeur connaît en réception le nombre de mots émis [22], [23].

**8.3-Décodage source hard et soft des codes RVLC**

*8.3.1-Décodage hard des codes RVLC*

Lors du décodage d'une séquence bruitée de mots VLC ou RVLC, certaines erreurs peuvent être détectées pour arrêter le décodage de la trame correspondante. Ces erreurs sont de plusieurs types [24] :

- valeur dépassant les limites existantes ;
- mot RVLC hors de la table existante ;
- nombre de mots détectées dépassant le nombre prévu.

Les deux premiers types d'erreurs correspondent au décodage d'un mot n'existant pas dans la table de Huffman.
La détection d'erreurs permet d'arrêter le décodage et de localiser grossièrement l'erreur. Avec des codes VLC, le reste de la trame est considéré comme perdu. Avec des codes RVLC, on peut commencer le décodage dans le sens retour en partant de la fin (en considérant que l'on sait où finit la séquence) jusqu'à la détection d'une erreur. L'utilisation des RVLC a donc permis de récupérer une partie des informations. Une stratégie possible de décodage est résumée dans [22]. Cette dernière distingue les cas où les décodages en sens aller et en sens retour détectent ou non une erreur.
Une solution pour pallier aux deux premiers types d'erreurs consiste à faire un décodage hard en cherchant, parmi les séquences autorisées, celle qui est la plus corrélée avec la séquence reçue. Cette recherche se fait à l'aide du treillis symbole réduit déjà commenté.

*8.3.2-Décodage soft conjoint source-canal des codes RVLC*

Jusqu'à présent plusieurs méthodes ont été proposées pour le décodage conjoint source-canal des codes VLC et RVLC.
La méthode optimale, mais très complexe, est celle de la multiplication des treillis canal et source [5].
Une méthode sous optimale est la mise en série des treillis canal et source discutée plus haut, éventuellement séparés par un entrelaceur si l'algorithme est itératif [20]. Cette méthode devient rapidement complexe avec le nombre de mots dans la table VLC ou RVLC.
Une autre méthode, très peu complexe, envisage la concaténation des deux treillis. Le décodage de canal est alors contrôlé par l'utilisation de l'information a priori sur la source, comme proposé plus haut.
Ces trois méthodes peuvent être utilisées conjointement avec les Turbo-Codes mais seules les deux dernières sont envisageables au niveau compromis gain/complexité de calcul.

Un premier nouveau procédé selon l'invention s'appuie sur la dernière méthode citée pour décoder les VLC et l'étend aux codes RVLC en utilisant un algorithme List-Viterbi de type parallèle ou de type série [25]. La nécessité de l'algorithme List-Virterbi pour le décodage des codes RVLC s'explique par le fait que, contrairement au cas du décodage des codes VLC, les séquences ne sont pas toutes autorisées à la réception. Un stockage des séquences autorisées les plus probables permet de les réutiliser pour le remplacement d'une séquence non-autorisée pendant la phase de décodage le long du treillis du décodeur de canal.

Ce nouveau procédé s'étend aussi au cas du décodage des VLC ou RVLC appliqué à des données réelles pour lequel, par exemple, on a une information a priori supplémentaire sur le nombre de mots de la séquence, sur l'intervalle de valeurs que peuvent prendre les coefficients.

Un second nouveau procédé de décodage des codes RVLC consiste à utiliser l'équivalent de l'algorithme List-Viterbi pour l'algorithme du SUBMAP [26], ceci dans les deux sens de décodage, comme illustré en figure 10. L'intérêt de travailler avec l'algorithme du SUBMAP vient de son mode de fonctionnement.

Cet algorithme se décompose en trois phases :

- phase "forward" 110 ou phase aller décodant la séquence dans un sens ;
- phase "backward" 111 ou phase retour décodant la séquence dans l'autre sens ;
- phase A Posteriori Probability (APP) 112 utilisant les résultats des deux phases précédentes pour retourner l'APP des bits décodés.

Le décodage des RVLC se fait aussi dans les deux sens grâce à leur propriété de décodage dans les deux sens. L'analogie entre le décodage de canal et le décodage de source montre qu'une combinaison des deux peut se révéler bénéfique. Ainsi, lors du décodage de la séquence reçue sur le treillis du décodeur de canal, chaque sens de décodage peut utiliser son information a priori 113. Pour utiliser au mieux l'information a priori dans le sens "backward", il est intéressant de savoir quel est l'état final du treillis. Cette information est obtenue soit en la transmettant, soit en mettant des bits de bourrage, soit en utilisant la technique du "tail-biting" ou du treillis circulaire [27].

L'information a priori utilisée peut être de deux types, comme déjà mentionné.

Une fois le décodage de canal soft réalisé en utilisant l'information a priori, la séquence soft obtenue n'est pas forcément une séquence autorisée car, bien que les phases forward et backward garantissent cette condition, la phase APP ne le garantit pas. Il est alors avantageux de faire suivre ce décodage de canal contrôlé par la source d'un treillis symbole réduit 114 donnant la séquence autorisée la plus probable.

## 8.4 Décodage soft source-canal utilisant les Turbo-Codes

Les méthodes de décodage citées précédemment s'appliquent avantageusement dans un schéma de type Turbo-Codes. Le codeur de canal est alors remplacé par les Turbo-codes, ce qui permet de garder le gain obtenu à faible rapport signal à bruit sur toute la gamme de rapports signal à bruit.

La première méthode consiste à utiliser le treillis source 120 en série avec les deux décodeurs comme le montre la figure 11.

La deuxième méthode reprend le deuxième principe décrit plus haut : le treillis canal utilise l'information a priori directement comme expliqué sur la figure 12. De même que pour la partie précédente, pour utiliser au mieux l'information a priori dans le sens backward, il est intéressant de savoir quel est l'état final du treillis. Cette information est obtenue soit en la transmettant, soit en mettant des bits de bourrage, soit en utilisant la technique du codage circulaire, équivalent pour les Recursive Systematic Codes (RSC) du "tail-biting" pour les Non Systematic Codes (NSC) [28].

## 9- Performances

On a montré la possibilité de réaliser un décodage à décision douce des codes de Huffman. Par rapport à des travaux déjà publiés, la méthode de l'invention permet de travailler au niveau bit. Il est ainsi possible d'introduire un bloc de décodage source à entrées et sorties pondérées, dit "SISO_huff", dans un schéma de décodage canal de type turbo-codes. Une autre possibilité est d'utiliser l'information a priori sur la source directement au niveau du décodeur de canal. Cette deuxième méthode est nettement moins complexe et donne des résultats équivalents à ceux obtenus avec "SISO_huff".

Les gains apportés par ce type de schéma dépend d'une part de la modélisation utilisée pour la source avec la connaissance a priori des probabilités des symboles de Huffman ou de leurs probabilités de transition, et d'autre part, du rapport $E_b/N_0$ sur le canal.

Dans les comparaisons que nous avons effectuées, nous évaluons nos gains par rapport au schéma tandem correspondant. Dans la gamme des taux d'erreur binaire autour de $10^{-2}$ à $10^{-3}$, les deux nouvelles techniques permettent des gains entre 0,5 et 1 dB dès leur première itération, ceci avec des codeurs NSC (en anglais : « Non Systematic Coder »).

Par ailleurs leur utilisation dans un schéma itératif de type Turbo-Codes améliore les performances de 0,5 à 1,5 dB le gain est fonction du rapport S/B et de la redondance résiduelle. De plus l'utilisation conjointe des 2 méthodes permet d'espérer un gain cumulé encore plus important.

Dans les fourchettes de gains annoncés, les valeurs les plus fortes sont obtenues à faible rapport signal à bruit, ce qui permet d'accroître notablement la plage de fonctionnement en transmission. A noter également que dans un schéma de type Turbo-Code, cela peut permettre de décaler d'autant, et donc de 0,5 à 1,5 dB, le point de déclenchement de l'effet Turbo-Codes.

Le premier procédé nécessite le déroulement d'un algorithme de décodage sur le treillis "SISO_huff" alors que le deuxième nécessite simplement une remise à jour d'une table lors du décodage sur le treillis du décodeur de canal. De plus, contrairement au premier procédé, le deuxième a une complexité de calcul qui n'augmente pas avec le nombre de mots dans la table VLC.

L'utilisation des codes à longueur variable de type Huffman étant très largement répandue, ces techniques de décodage peuvent convenir dans de nombreux contextes. Les applications sont multiples. On retrouve par exemple des tables de Huffman dans la norme MPEG4 pour le codage des coefficients de la bande DC et de la bande AC pour les images codées en intra mais aussi pour le codage des vecteurs de mouvement.

L'invention peut également être utilisée dans une chaîne de transmission plus complète en prenant en compte un système de codage d'images à la norme, ou proche de la norme, et un modèle de canal représentatif du canal radio-mobile comme BRAN (« Broadcast Radio Network »).


**ANNEXE A**


**Codage de Huffman**


Le code de Huffman ([18]) est un codage entropique qui compresse une source en codant les données peu probables sur une longueur biliaire supérieure à la moyenne et ceux très probables sur une longueur binaire courte. Le code de Huffman est très utilisé car il n'existe pas d'autres codes entier (dont les symboles sont codés sur un nombre entier de bits) qui donne un plus faible nombre moyen de bits par symbole. Une de ses caractéristiques essentielles est qu'une séquence binaire ne peut jamais être à la fois représentative d'un élément codé et constituer le début du code d'un autre élément. Cette caractéristique du codage de Huffman permet une représentation à l'aide d'une structure d'arbre binaire où l'ensemble des mots est représenté par l'ensemble des chemins de la racine de l'arbre aux feuilles de l'arbre.

Il existe plusieurs façon de présenter la construction du code de Huffman. Celle qui semble la plus simple est basée sur une structure d'arbre.

Soient les $N$ mots $a_i$ de probabilités respectives $p(a_i)$. L'arbre est construit à partir de ses $N$ sommets terminaux.

Chaque sommet terminal $i$ est affecté de la probabilité $p(a_i)$ et permettra d'avoir la décomposition binaire du mot $a_i$.

L'algorithme de construction de l'arbre consiste à chaque étape à sommer les deux probabilités les plus faibles de l'étape précédente pour les réunir en un sommet affecté de la probabilité somme.

A la dernière étape, on obtient un sommet de probabilité 1, c'est la racine de l'arbre.

Il reste à étiqueter les branches de l'arbre obtenu en indexant par un 1 les branches de droite de chaque sommet et par 0 les branches de gauche. La décomposition binaire du mot $a_i$ est alors obtenue en descendant l'arbre en partant du sommet de probabilité 1 jusqu'au sommet $i$.

L'exemple expliqué prend le cas de 4 mots comme le montre la figure 6.

TAB. 1 -

| *Exemple de table de Huffman.* | | |
|---|---|---|
| Mot | Probabilité | Code binaire |
| $a_0$ | $p(a_0)$ | 111 |
| $a_1$ | $p(a_1)$ | 110 |
| $a_2$ | $p(a_2)$ | 10 |
| $a_3$ | $p(a_3)$ | 0 |

**ANNEXE B**

**Décodage source de symboles indépendants ou markoviens**

Deux structures optimales sont utilisées pour le décodage d'une séquence codée. Chacune se base sur un critère différent, le critère de la séquence la plus vraisemblable ou le critère du symbole le plus vraisemblable couramment appelé MAP (Maximum A Posteriori).

**1 Algorithme de Viterbi**

La recherche de la séquence la plus vraisemblable se fait avec l'algorithme de Viterbi [9] qui cherche la séquence X émise la plus probable connaissant la séquence $Y$ reçue:

$$\max_X P(X/Y) \qquad (1)$$

Comme la fonction logarithme est strictement croissante, il est équivalent de maximiser log $P(X/Y)$

$$\max_X \log P(X/Y) \qquad (2)$$

En appliquant la loi de Bayes:

$$P(X/Y)P(Y) = P(Y/X)P(X) \qquad (3)$$

le critère devient:

$$\max_X [\log P(Y/X) + \log P(X)] \qquad (4)$$

L'information a posteriori sur $X$ se décompose en deux termes. Le premier log $P(Y/X)$ concerne l'information fournie par le canal, le second log $P(X)$ concerne l'information a priori sur la séquence émise.

Si les échantillons de bruit du canal sont indépendants alors la loi du bruit $P(Y/X)$ s'exprime comme le produit des lois de probabilités des bruits perturbant chacun des mots $x^i$ et $y^i$ et des bits transmis $x_j^i$ et $y_j^i$:

$$\log P(Y/X) = \log \prod_i \prod_j p(y_j^i / x_j^i) \qquad (5)$$

En ce qui concerne la probabilité a priori $P(X)$, les deux hypothèses envisagées sont:

- les mots émis par la source sont indépendants :

$$\begin{aligned} \log P(X) &= \log \prod_i p(x^i) \\ &= \sum_i \log p(x^i) \qquad (6) \end{aligned}$$

- les mots émis suivent un processus de Markov d'ordre 1 comme par exemple dans le cas d'un codeur d'image en sous-bandes pour ce qui concerne la composante continue. On a alors

$$\log P(X) \;=\; \log \prod_i p(x^i/x^{i-1})$$
$$=\; \sum_i \log p(x^i/x^{i-1}) \qquad\qquad (7)$$

Classiquement, le décodage suivant l'algorithme de Viterbi comprend une phase d'ACS (Add Compare Select) : à chaque étage et à chaque état, on additionne la métrique de la branche associée à chacune des deux séquences concurrentes, on compare les deux métriques obtenues et on sélectionne la séquence de métrique la plus faible.

## 2 Algorithme du MAP

Le décodage selon le MAP se fait suivant la règle ci-dessous :

$$x_j^i = \begin{cases} +1 & p(x_j^i = +1/Y) > p(x_j^i = -1/Y) \\ -1 & \text{sinon} \end{cases}$$

Le calcul de la probabilité $p(x_j^i = +1/Y)$ est complexe. Cette complexité peut-être réduite au prix d'une perte en performances. L'algorithme moins complexe est appelé algorithme SUBMAP [11].

## 3 Pondération des décisions du décodeur

Cette pondération est une information de fiabilité sur l'estimation réalisée par le décodeur. Cette information "soft", parfois appelée information extrinsèque, est utilisable par un décodeur externe, un décodeur de source ou tout autre dispositif intervenant dans la réception de l'information [12].
Plusieurs algorithmes fournissent des décisions pondérées sur les valeurs décodées:

- l'algorithme SOVA (Soft Output Viterbi Algorithm) [13] se base sur une légère modification de l'algorithme de Viterbi;

- l'algorithme BCJR (Bahl Cocke Jelinek Raviv) [14] est établi sur le critère du MAP.

Une source codée VLC ou issue d'un codeur de canal peut être représentée par un treillis duquel on peut extraire de l'information extrinsèque. Une partie de l'invention propose de construire un tel treillis à partir du code VLC de la source.

**ANNEXE C**

**Références**

[1] C. Berrou, A. Glavieux, and P. Thitimajshima. "Near Shannon limit error-correcting coding and decoding: Turbo-Codes". *Proceedings of ICC*, pages 1064-1070, May 1993.

[2] C. E. Shaanon. "*A Mathematical Theory of Communication*", volume 27. Bell System Tech. J., 1948.

[3] S. B. Zahir Azami. "*Codage conjoint Source/Canal, protection hiérarchi que*". PhD thesis, ENST Paris, May 1999.

[4] N. Dernir and K. Sayood. "Joint source/channel coding for variable length codes". In *Data Compression Conference (DCC),* pages 139-148, Snowbird, Utah, USA, March 1998.

[5] A. H. Murad and T. E. Fuja. "Joint source-channel decoding of variable length encoded sources". In *Information*

*Theory Workshop (ITW)*, pages 94-95, Killarney, Ireland, June 1998.

[6] K. P. Subbalakshmi and J. Vaisey. "Joint source-channel decoding of entropy coded Markov sources over binary symmetric channels". In *Proceedings of ICC*, page Session 12, Vancouver, Canada, June 1999.

[7] J. Wien and J. D. Villasenor. "Utilizing soft information in decoding of variable length codes". In *Data Compression Conference (DCC),* Snowbird, Utah, March 1999.

[8] Y. Takishima, M. Wada, and H. Murakami. "Reversible variable length codes". *IEEE Transactions on Communications,* 43:158-162, 1995.

[9] A. Viterbi. "Error bounds for convolutional codes and an asymptotically optimal decoding algorithm". *IEEE Transactions on Information Theory,* 13:260-269, 1967.

[10] W. Koch and A. Baier. "Optimum and sub-optimum detection of coded data disturbed by time-varying intersymbol interference". *Proceedings GLOBECOM*, pages 1679-1684, December 1990.

[11] P. Robertson, E. Villebrun, and P. Hoeher. "A comparaison of optimal and sub-optimal map decoding algorithms operating in the log-domain". In *Proceedings of ICC*, pages 1009-1013, Seattle, Washington, June 1995.

[12] J. Hagenauer. *"Soft-in/Soft-out: the benefit of using soft values in all stages of digital receiver*". Institute for communications technology, 1990.

[13] J. Hagenauer and P. Hoeher. "A Viterbi algorithm with soft-decision outputs and its applications". *Proceedings GLOBECOM*, pages 1680-1686, November 1989.

[14] L. R. Bahl, J. Cocke, F. Jelinek, and J. Raviv. "Optimal decoding of linear codes for minimizing symbol error rate". *IEEE Transactions on Information Theory*, pages 284-287, March 1974.

[15] S. Benedetto and G. Montorsi. "Generalized concatenated codes with interleavers". In *International Symposium on Turbocodes*, pages 32-39, Brest, September 1997.

[16] J. Hagenauer. "Source-controlled channel decoding". *IEEE Transactions on Communications*, 43:2449-2457, September 1995.

[17] A. E. Escott and S. Perkins. "Binary Huffman equivalent codes with a short synchronizing codeword". *IEEE Transactions on Information Theory*, 44:346-351, January 1998.

[18] D. A. Huffman. "Method for the reconstruction of minimum redundancy codes". *Key Papers* in *The development of Information Theory*, pages 47-50, 1952.

[19] K. Sayood and J.C. Borkenhagen. "Utilization of correlation in low rate dpcm systems for channel error protection". In *Proceedings of ICC*, pages 1888-1892, June 1986.

**Références**

[20] R. Bauer and J. Hagenauer. "Iterative source/channel deoding using reversible variable length codes". In *Data Compression Conference (DCC)*, Snowbird, Utah, March 2000.
[21] J. Wien and J.D. Villasenor. "A class of reversible variable length codes for robust image and video coding". In *ICIP*, volume 2, pages 65-68, Santa Barbara, CA, October 1997.
[22] A. H. Murad and T.E. Fuja. "Robust transmission of variable-length encoded sources". In *IEEE Wireless Communications and Networking Conference,* New Orleans, L.A., September 1999.
[23] A.H. Murad and T.E. Fuja. "Variable length source codes, channel codes, and list-decoding'. In *information Theory Workshop (ITW)*, Kruger national park, South Africa, June 1999;
[24] Video Group. *"Error-resilient video coding in the ISO MPEG4 standard*". R. Talluri, 1997.
[25] N.Seshadri and C.E. Sundberg. "List Viterbi decoding algorithms with applications". *IEEE transactions on*

*communications,* 42 : 313-323, February 1994.

[26] P. Robertson, E. Villebrun, and P. Hoeher. "A comparaison of optimal and suboptimal map decoding algorithms operating in the log-domain". In *Proceedings of ICC*, pages 1009-1013, Seattle, Washington, June 1995,

[27] J.C. Carlach, D. Castelain, and P. Combelles. "Soft-decoding of convolutional block codes for an interactive television return channel". In *International Conference on Universal Communications Records*, pages 249-253, San Diego, CA, October 1997.

[28] C. Berrou, C. Douillard, and M. Jezequel. "Multiple parallel concatenation of circular recursive systematic concolutional (CRSC) codes". In *Annales des télécommunications,* pages 166-172, March 1997.

**Revendications**

1. Procédé de décodage de données numériques reçues correspondant à des données numériques émises codées à l'aide d'un code entropique associant à chacun des mots d'un alphabet une séquence de bits distincte, dont la longueur est fonction de la probabilité d'occurrence dudit mot,
   **caractérisé en ce qu'**il met en oeuvre un treillis de décodage dont chaque transition correspond à une valeur binaire 0 ou 1 d'un des bits d'une séquence de bits correspondant à l'un desdits mots.

2. Procédé de décodage selon la revendication 1, ledit code entropique étant représenté sous la forme d'un arbre binaire comprenant un noeud racine, une pluralité de noeuds intermédiaires et une pluralité de noeuds feuilles, une séquence de bits correspondant à un desdits mots étant formée en considérant les transitions successives dudit arbre depuis ledit noeud racine jusqu'au noeud feuille associé audit mot,
   **caractérisé en ce que** les états de chaque étage dudit treillis comprennent un unique état dit extrémal, correspondant audit noeud racine et à l'ensemble desdits noeuds feuilles, et un état distinct, dit état intermédiaire pour chacun desdits noeuds intermédiaires.

3. Procédé de décodage selon l'une quelconque des revendications 1 et 2, **caractérisé en ce que** l'on associe à chaque transition dudit treillis une information de vraisemblance.

4. Procédé de décodage selon la revendication 3, **caractérisé en ce que** ladite information de vraisemblance est une métrique tenant compte d'une part d'une information représentative du canal de transmission et d'autre part d'une information a priori sur ledit code entropique.

5. Procédé de décodage selon la revendication 4, **caractérisé en ce que** ladite information a priori appartient au groupe comprenant :

   - le code entropique mis en oeuvre ; et /ou
   - les probabilités a priori de chacun desdits mots du code ; et/ou
   - le nombre de mots émis ; et/ou
   - des valeurs limites pour les coefficients.

6. Procédé de décodage selon la revendication 4 ou 5, **caractérisé en ce que** l'on calcule, pour chacune desdites transitions, la métrique suivante :

$$\Gamma_i[(x_k, x_k^p), d_k, d_{k-1}] = \Pr(x_k/a_k = i)\Pr(y_k^p/a_k = i, d_k, d_{k-1})\Pr\{a_k = i, d_k/d_{k-1}\}$$

7. Procédé de décodage selon l'une quelconque des revendications 1 à 6, **caractérisé en ce que** ledit code entropique appartient au groupe comprenant :

   - les codes de Huffman ;
   - les codes à longueur variable réversibles (RVLC).

8. Procédé de décodage selon la revendication 7, **caractérisé en ce que** ledit code entropique étant un code RVLC, ladite information a priori est utilisée pour une phase aller de parcours dudit treillis et une phase retour de parcours dudit treillis.

9. Procédé de décodage selon l'une quelconque des revendications 1 à 8, mettant en oeuvre un décodage conjoint source-canal d'un signal numérique reçu, le codage source mettant en oeuvre un code entropique associant à chacun des mots d'un alphabet une séquence de bits distincte, dont la longueur est fonction de la probabilité d'occurrence dudit mot,

**caractérisé en ce qu'**il met en oeuvre un décodage source utilisant au moins un treillis de décodage dont chaque transition correspond à une valeur binaire 0 ou 1 d'un des bits de la séquence de bits correspondant à l'un desdits mots, ledit décodage source délivrant une information extrinsèque au décodage canal.

**10.** Procédé de décodage conjoint selon la revendication 9, **caractérisé en ce que** le décodage canal met en oeuvre un décodage de type turbo-code.

**11.** Procédé de décodage conjoint selon la revendication 10, **caractérisé en ce que** ledit décodage de type turbo-code repose sur une mise en oeuvre de type parallèle.

**12.** Procédé de décodage conjoint selon la revendication 10, **caractérisé en ce que** ledit décodage de type turbo-code repose sur une mise en oeuvre de type série.

**13.** Procédé de décodage conjoint selon l'une quelconque des revendications 9 à 12, **caractérisé en ce qu'**il repose sur une mise en oeuvre itérative.

**14.** Procédé de décodage conjoint selon la revendication 13, **caractérisé en ce que** chacune des itérations comprend séquentiellement une étape de décodage canal et une étape de décodage source, ladite étape de décodage canal délivrant une information de canal prise en compte dans ladite étape de décodage source, cette dernière délivrant une information a priori prise en compte dans ladite étape de décodage canal.

**15.** Procédé de décodage conjoint selon la revendication 14, **caractérisé en ce qu'**il comprend :

- une première étape de décodage canal ;
- une première étape de décodage source, alimentée par ladite première étape de décodage canal ;
- une seconde étape de décodage canal, alimentée par ladite première étape de décodage canal et ladite première étape de décodage source, via un entrelaceur identique à l'entrelaceur mis en oeuvre au codage, et alimentant ladite première étape de décodage canal, via un désentrelaceur symétrique audit entrelaceur ;
- une seconde étape de décodage source alimentée par ladite seconde étape de décodage canal via ledit désentrelaceur, et alimentant ladite première étape de décodage canal.

**16.** Procédé de décodage selon l'une quelconque des revendications 1 à 15, mettant en oeuvre un décodage conjoint source-canal d'un signal numérique reçu, le codage source mettant en oeuvre un code entropique associant à chacun des mots d'un alphabet une séquence de bits distincte, dont la longueur est fonction de la probabilité d'occurrence dudit mot,

**caractérisé en ce qu'**il met en oeuvre un treillis de décodage canal, similaire au treillis de codage canal, dans lequel on associe à chaque état de chaque étage une information représentative d'une séquence, passant par cet état, de bits décodés du passé, par rapport au sens de parcours dudit treillis.

**17.** Procédé de décodage conjoint selon la revendication 16, **caractérisé en ce que** ladite information désigne la position du bit considéré dans l'arbre représentant ledit code entropique et/ou une information de vérification du nombre de mots décodés et/ou de la valeur prise par lesdits bits décodés.

**18.** Procédé de décodage conjoint selon la revendication 17, **caractérisé en ce qu'**il comprend, pour chacun desdits états, les étapes suivantes :

- ajout, aux deux branches arrivant dans ledit état, de la métrique du canal et de la métrique de la source ;
- comparaison des deux nouvelles métriques obtenues, et sélection de la métrique la plus faible ;
- si ladite information désignant la position indique la fin d'un mot, considérer que le noeud est une feuille de l'arbre, sinon, passer au noeud suivant dans l'arbre.

**19.** Procédé de décodage conjoint selon l'une quelconque des revendications 16 à 18, **caractérisé en ce qu'**il met en oeuvre une procédure itérative.

**20.** Procédé de décodage conjoint selon la revendication 19, **caractérisé en ce qu'**il comprend les étapes suivantes :

- premier décodage canal, mettant en oeuvre un treillis de décodage canal dont chaque état dispose d'une information désignant la position du bit considéré dans l'arbre représentant ledit code entropique ;
- deuxième décodage canal, alimenté par ledit premier décodage canal, via un entrelaceur identique à celui mis en oeuvre au codage, et alimentant ledit premier décodage canal, via un désentrelaceur symétrique dudit entrelaceur ;
- décodage source, alimenté par ledit deuxième décodage canal, via ledit désentrelaceur.

21. Procédé de décodage selon la revendication 20, **caractérisé en ce qu'**il met oeuvre un décodage de type turbo-code.

22. Procédé de décodage conjoint selon l'une quelconque des revendications 10 à 15 et 21, **caractérisé en ce que** chaque itération dudit décodage de type turbo-code met en oeuvre une matrice en bloc, présentant des lignes et des colonnes, sur laquelle est effectuée un décodage des lignes (respectivement colonnes) suivi d'un décodage des colonnes (respectivement lignes), et **en ce que** l'on utilise ladite information a priori pour ledit décodage des lignes (respectivement colonnes).

23. Procédé de décodage conjoint selon la revendication 22, **caractérisé en ce que** chaque ligne (respectivement colonne) correspond à un mot de code, formé de $k$ bits d'information.

24. Procédé de décodage conjoint selon l'une quelconque des revendications 9 à 23, **caractérisé en ce que** ledit code entropique est un code à longueur variable réversible (RVLC).

25. Procédé de décodage conjoint selon la revendication 24, **caractérisé en ce qu'**on concatène les treillis de décodage canal et de décodage source, ledit décodage de canal étant contrôlé par une information a priori sur la source.

26. Procédé de décodage conjoint selon la revendication 25, **caractérisé en ce qu'**il met en oeuvre un algorithme dit "list Viterbi", de type parallèle ou de type série, associé à une étape de remplacement d'une séquence non-autorisée par le codage par la séquence autorisée la plus probable, lors du parcours du treillis du décodage de canal.

27. Procédé de décodage selon la revendication 25, **caractérisé en ce qu'**il met en oeuvre un algorithme dit "du SUBMAP", dans les sens de parcours aller et retour du treillis de décodage de canal.

28. Procédé de décodage conjoint selon l'une quelconque des revendications 22 à 27, **caractérisé en ce qu'**il met en oeuvre une étape de détection du début et/ou de fin de chacun des mots de code.

29. Procédé de décodage conjoint selon la revendication 28, **caractérisé en ce que** ladite étape de détection repose sur la mise en oeuvre d'au moins une des techniques appartenant au groupe comprenant :

- insertion d'une information de début et/ou de fin de mot, à l'émission ;
- insertion de bits de bourrage, de façon que les mots, accompagnés des bits de bourrage, aient une longueur constante ;
- utilisation de la technique dite "bit-tailing" ;
- utilisation d'un treillis circulaire.

30. Procédé de décodage selon l'une quelconque des revendications 1 à 29, **caractérisé en ce qu'**il comprend en outre une étape de recherche de la séquence autorisée la plus probable, à l'aide d'un treillis symbole réduit, présentant un état de départ unique (d0) duquel partent et arrivent autant de mots qu'il existe de mots de code.

31. Dispositif de décodage de données numériques reçues correspondant à des données numériques émises codées à l'aide d'un code entropique associant à chacun des mots d'un alphabet une séquence de bits distincte, dont la longueur est fonction de la probabilité d'occurrence dudit mot, mettant en oeuvre le procédé de décodage selon l'une quelconque des revendications 1 à 30, **caractérisé en ce qu'**il comprend des moyens de mise en oeuvre d'un treillis de décodage dont chaque transition correspond à une valeur binaire 0 ou 1 d'un des bits d'une séquence de bits correspondant à l'un desdits mots.

32. Système de transmission d'un signal numérique, **caractérisé en ce qu'**il met en oeuvre, à l'émission, un codage source entropique et un codage canal, et à la réception, un décodage selon le procédé de l'une quelconque des revendications 1 à 30, **caractérisé en ce qu'**il comprend des moyens de mise en oeuvre d' un treillis de décodage dont chaque transition correspond à une valeur binaire 0 ou 1 d'un des bits d'une séquence de bits correspondant à l'un desdits mots.

## Claims

1. Method for decoding received digital data corresponding to transmitted digital data coded with the aid of an entropic code associating a distinct bit sequence with each of the words of an alphabet, the length of which bit sequence is a function of the occurrence probability of the said word,
   **characterised in that** it implements a decoding lattice in which each transition corresponds to a binary value 0 or 1 of one of the bits in a bit sequence corresponding to one of the said words.

2. Decoding method according to Claim 1, the said entropic code being represented in the form of a binary tree comprising a root node, a plurality of intermediate nodes and a plurality of leaf nodes, a bit sequence corresponding to one of the said words being formed by considering the successive transitions in the said tree from the said root node as far as the leaf node associated with the said word,
   **characterised in that** the states of each stage of the said lattice comprise a unique so-called extreme state, corresponding to the said root node and to all the said leaf nodes, and a distinct state, referred to as an intermediate state, for each of the said intermediate nodes.

3. Decoding method according to either one of Claims 1 and 2, **characterised in that** likelihood information is associated with each transition in the said lattice.

4. Decoding method according to Claim 3, **characterised in that** the said likelihood information is a metric taking into account, on the one hand, information representing the transmission channel and, on the other hand, a priori information about the said entropic code.

5. Decoding method according to Claim 4, **characterised in that** the said a priori information belongs to the group comprising:

   - the entropic code being implemented; and/or
   - the a priori probabilities of each of the said words of the code; and/or
   - the number of words transmitted; and/or
   - limit values for the coefficients.

6. Decoding method according to Claim 4 or 5, **characterised in that** the following metric is calculated for each of the said transitions:

$$\Gamma_i[(x_k, x_k^p), d_k, d_{k-1}] = \Pr(x_k/a_k = i)\Pr(y_k^p/a_k = i, d_k, d_{k-1})\Pr\{a_k = i, d_k/d_{k-1}\}$$

7. Decoding method according to any one of Claims 1 to 6, **characterised in that** the said entropic code belongs to the group comprising:

   - Huffman codes;
   - reversible variable length codes (RVLC).

8. Decoding method according to Claim 7, **characterised in that**, the said entropic code being an RVLC code, the said a priori information is used for a phase of forward passage through the said lattice and a phase of return passage through the said lattice.

9. Decoding method according to any one of Claims 1 to 8, implementing joint source-channel decoding of a received digital signal, the source code implementing an entropic code associating a distinct bit sequence with each of the words of an alphabet, the length of which bit sequence is a function of the occurrence probability of the said word,
   **characterised in that** it implements source decoding using at least one decoding lattice in which each transition corresponds to a binary value 0 or 1 of one of the bits in the bit sequence corresponding to one of the said words, the said source decoding delivering information extrinsic to the channel decoding.

10. Joint decoding method according to Claim 9, **characterised in that** the channel decoding implements decoding of the turbo-code type.

11. Joint decoding method according to Claim 10, **characterised in that** the said decoding of the turbo-code type is based on an implementation of the parallel type.

12. Joint decoding method according to Claim 10, **characterised in that** the said decoding of the turbo-code type is based on an implementation of the series type.

13. Joint decoding method according to any one of Claims 9 to 12, **characterised in that** it is based on an iterative implementation.

14. Joint decoding method according to Claim 13, **characterised in that** each of the iterations sequentially comprises a channel decoding step and a source decoding step, the said channel decoding step delivering channel information taken into account in the said source decoding step, the latter delivering a priori information taken into account in the said channel decoding step.

15. Joint decoding method according to Claim 14, **characterised in that** it comprises:

   - a first channel decoding step;
   - a first source decoding step, fed by the said first channel decoding step;
   - a second channel decoding step, fed by the said first channel decoding step and the said first source decoding step via an interleaver identical to the interleaver implemented in the coding, and feeding the said first channel decoding step via a de-interleaver symmetrical with the said interleaver;
   - a second source decoding step, fed by the said second channel decoding step via the said de-interleaver, and feeding the said first channel decoding step.

16. Decoding method according to any one of Claims 1 to 15, implementing joint source-channel decoding of a received digital signal, the source code implementing an entropic code associating a distinct bit sequence with each of the words of an alphabet, the length of which bit sequence is a function of the occurrence probability of the said word, **characterised in that** it implements a channel decoding lattice similar to the channel coding lattice, in which information is associated with each state of each stage, this information representing a sequence, passing through this state, of bits decoded in the past with respect to the direction of passage through the said lattice.

17. Joint decoding method according to Claim 16, **characterised in that** the said information designates the position of the relevant bit in the tree representing the said entropic code and/or information for verifying the number of words decoded and/or the value taken by the said decoded bits.

18. Joint decoding method according to Claim 17, **characterised in that** it comprises the following steps for each of the said states:

   - adding the metric of the channel and the metric of the source to the two branches arriving in the said state;
   - comparing the two new metrics which are obtained, and selecting the smaller metric;
   - if the said information designating the position indicates the end of a word, considering the node to be a leaf of the tree, otherwise moving on to the next node in the tree.

19. Joint decoding method according to any one of Claims 16 to 18, **characterised in that** it implements an iterative procedure.

20. Joint decoding method according to Claim 19, **characterised in that** it comprises the following steps:

   - first channel decoding, implementing a channel decoding lattice in which each state has information designating the position of the relevant bit in the tree representing the said entropic code;
   - second channel decoding, fed by the said first channel decoding via an interleaver identical to the one implemented in the coding, and feeding the said first channel decoding via a de-interleaver symmetrical with the said interleaver;

- source decoding, fed by the said second channel decoding via the said de-interleaver.

21. Decoding method according to Claim 20, **characterised in that** it implements decoding of the turbo-code type.

22. Joint decoding method according to any one of Claims 10 to 15 and 21, **characterised in that** each iteration of the said decoding of the turbo-code type implements a block matrix, having rows and columns, on which row (respectively column) decoding is carried out, followed by column (respectively row) decoding,
and **in that** the said a priori information is used for the said row (respectively column) decoding.

23. Joint decoding method according to Claim 22, **characterised in that** each row (respectively column) corresponds to a code word formed by $k$ information bits.

24. Joint decoding method according to any one of Claims 9 to 23, **characterised in that** the said entropic code is a reversible variable length code (RVLC).

25. Joint decoding method according to Claim 24, **characterised in that** the channel decoding and source decoding lattices are concatenated, the said channel decoding being controlled by a priori information about the source.

26. Joint decoding method according to Claim 25, **characterised in that** it implements a so-called "Viterbi list" algorithm, of the parallel type or of the series type, associated with a step of replacing a sequence not authorised by the coding with the most probable authorised sequence, during passage through the lattice of the channel decoding.

27. Decoding method according to Claim 25, **characterised in that** it implements a so-called "SUBMAP" algorithm in the forward and return directions of passage through the channel decoding lattice.

28. Joint decoding method according to any one of Claims 22 to 27, **characterised in that** it implements a step of detecting the start and/or end of each of the code words.

29. Joint decoding method according to Claim 28, **characterised in that** the said detection step is based on implementing at least one of the techniques belonging to the group comprising:

- inserting start and/or end of word information at transmission;
- inserting padding bits, so that the words accompanied by the padding bits have a constant length;
- using the so-called "bit-tailing" technique;
- using a circular lattice.

30. Decoding method according to any one of Claims 1 to 29, **characterised in that** it furthermore comprises a step of searching for the most probable authorised sequence, with the aid of a reduced symbol lattice having a unique starting state (d0) from which as many words depart and arrive as there are code words.

31. Device for decoding received digital data corresponding to transmitted digital data coded with the aid of an entropic code associating a distinct bit sequence with each of the words of an alphabet, the length of which bit sequence is a function of the occurrence probability of the said word, implementing the decoding method according to any one of Claims 1 to 30, **characterised in that** it comprises means for implementing a decoding lattice in which each transition corresponds to a binary value 0 or 1 of one of the bits in a bit sequence corresponding to one of the said words.

32. System for transmitting a digital signal, **characterised in that** it implements entropic source coding and channel coding at transmission, and decoding according to the method of any one of Claims 1 to 30 at reception, **characterised in that** it comprises means for implementing a decoding lattice in which each transition corresponds to a binary value 0 or 1 of one of the bits in a bit sequence corresponding to one of the said words.

**Patentansprüche**

1. Verfahren zum Dekodieren von empfangenen Digitaldaten, die gesendeten Digitaldaten entsprechen, welche mittels eines entropischen Codes codiert worden sind, der einem jeden Wort eines Alphabets eine unterschiedliche Bitfolge zuordnet, deren Länge eine Funktion der Auftrittswahrscheinlichkeit dieses Wortes ist,
**dadurch gekennzeichnet, dass** es ein Dekodiergitter verwendet, bei dem jeder Übergang einem Binärwert von 0 oder 1 eines der Bits einer Bitfolge entspricht, die einem der genannten Wörter entspricht.

**2.** Dekodierverfahren nach Anspruch 1, wobei der entropische Code in der Form eines binären Baums dargestellt, wird, der einen Wurzelknoten, eine Vielzahl von Zwischenknoten und eine Vielzahl von Blattknoten umfasst, wobei eine Bitfolge, die einem der erwähnten Wörter entspricht, die unter Berücksichtigung der aufeinanderfolgenden Übergänge des Baums gebildet werden, vom Wurzelknoten bis zu dem dem besagten Wort zugeordneten Blattknoten,
**dadurch gekennzeichnet, dass** die Zustände einer jeden Stufe des Gitters einen einzigen, extremal genannten Zustand umfassen, der dem Wurzelknoten und der Menge der Blattknoten entspricht sowie einen verschiedentlichen, Zwischenzustand genannten Zustand, für jeden der Zwischenknoten.

**3.** Dekodierverfahren nach einem der Ansprüche 1 oder 2, **dadurch gekennzeichnet, dass** man einem jeden Übergang des Gitters eine Wahrscheinlichkeitsinformation zuordnet.

**4.** Dekodierverfahren nach Anspruch 3, **dadurch gekennzeichnet, dass** die Wahrscheinlichkeitsinformation eine Metrik ist, die einerseits eine für den Sendekanal repräsentative Information und andererseits eine a priori Information über den erwähnten entropischen Code berücksichtigt.

**5.** Dekodierverfahren nach Anspruch 4, **dadurch gekennzeichnet, dass** die a priori Information der Gruppe angehört, die folgendes umfasst:

- die eingesetzten entropischen Codes und/oder
- die a priori Wahrscheinlichkeiten eines jeden Wortes des Codes und/oder
- die Zahl der gesendeten Wörter und/oder
- Grenzwerte für die Koeffizienten.

**6.** Dekodierverfahren nach einem der Ansprüche 4 oder 5, **dadurch gekennzeichnet, dass** man für einen jeden der erwähnten Übergänge die folgende Metrik berechnet:

$$\Gamma_i[(x_k, x_k^p), d_k, d_{k-1}] = Pr\,(x_k/a_k = i)\,Pr\,(y_k^p/a_k = i, d_k, d_{k-1})\,Pr\,\{a_k = i, d_k / d_{k-1}\}$$

**7.** Dekodierverfahren nach einem der Ansprüche 1 bis 6, **dadurch gekennzeichnet, dass** der entropische Code der Gruppe angehört, die folgendes umfasst:

- die Huffman-Codes;
- die reversiblen Codes variabler Länge (RVLC).

**8.** Dekodierverfahren nach Anspruche 7, **dadurch gekennzeichnet, dass** aufgrund der Tatsache, dass der entropische Code ein RVLC-Code ist, die erwähnte a priori Information für eine Vorlaufphase des erwähnten Gitters und eine Rücklaufphase des erwähnten Gitters benutzt wird.

**9.** Dekodierverfahren nach einem der Ansprüche 1 bis 8, wobei eine gemeinsame Quellen-Kanal-Dekodierung eines empfangenen digitalen Signals angewandt wird, wobei die Quellenkodierung einen entropischen Code verwendet, der einem jeden Wort eines Alphabets eine unterschiedliche Bitfolge zuordnet, deren Länge eine Funktion der Auftrittswahrscheinlichkeit des Wortes ist,
**dadurch gekennzeichnet, dass** es eine Quellendekodierung einsetzt, die mindestens ein Dekodiergitter verwendet, von dem jeder Übergang einem Binärwert von 0 oder 1 eines der Bits einer Bitfolge entspricht, die einem der erwähnten Wörter entspricht, wobei die Quellendekodierung eine der Kanaldekodierung nicht zugehörende Information liefert.

**10.** Gemeinschaftliches Dekodierverfahren nach Anspruch 9, **dadurch gekennzeichnet, dass** die Kanaldekodierung eine Dekodierung des Typs Turbo-Code verwendet.

**11.** Gemeinschaftliches Dekodierverfahren nach Anspruch 10, **dadurch gekennzeichnet, dass** die Dekodierung des Typs Turbo-Code auf einer Anwendung des parallelen Typs beruht.

**12.** Gemeinschaftliches Dekodierverfahren nach Anspruch 10, **dadurch gekennzeichnet, dass** die Dekodierung des Typs Turbo-Code auf einer Anwendung des seriellen Typs beruht.

**13.** Gemeinschaftliches Dekodierverfahren nach einem der Ansprüche 9 bis 12, **dadurch gekennzeichnet, dass** es auf einer iterativen Anwendung beruht.

**14.** Gemeinschaftliches Dekodierverfahren nach Anspruch 13, **dadurch gekennzeichnet, dass** jede der Iterationen sequentiell einen Schritt der Kanaldekodierung und einen Schritt der Quellendekodierung umfasst, wobei der Schritt der Kanaldekodierung eine Kanalinformation liefert, die bei dem Schritt der Quellendekodierung berücksichtigt wird, wobei letztere eine a priori Information liefert, die bei dem Schritt der Kanaldekodierung berücksichtigt wird.

**15.** Gemeinschaftliches Dekodierverfahren nach Anspruch 14, **dadurch gekennzeichnet, dass** es folgendes umfasst:

- einen ersten Schritt der Kanaldekodierung,
- einen ersten Schritt der Quellendekodierung, die vom ersten Schritt der Kanaldekodierung gespeist wird;
- einen zweiten Schritt der Kanaldekodierung, der vom ersten Schritt der Kanaldekodierung und dem ersten Schritt der Quellendekodierung gespeist wird, über eine Verschachtelungsvorrichtung, die identisch ist mit der beim Kodieren verwendeten Verschachtelungsvorrichtung und welche den ersten Schritt der Kanaldekodierung über eine zur erwähnten Verschachtelungsvorrichtung symmetrischen Entschachtelungsvorrichtung speist;
- einen zweiten Schritt der Quellendekodierung, der vom zweiten Schritt der Kanaldekodierung über die erwähnten Entschachtelungsvorrichtung gespeist wird und die den erwähnten ersten Schritt der Kanaldekodierung speist.

**16.** Dekodierverfahren nach einem der Ansprüche 1 bis 15, wobei eine gemeinsame Quellen-Kanal-Dekodierung eines empfangenen digitalen Signals angewandt wird, wobei die Quellenkodierung einen entropischen Code verwendet, der einem jeden Wort eines Alphabets eine unterschiedliche Bitfolge zuordnet, deren Länge eine Funktion der Auftrittswahrscheinlichkeit dieses Wortes ist,
**dadurch gekennzeichnet, dass** es ein Kanaldekodiergitter einsetzt, das dem Kanalkodiergitter ähnlich ist, bei dem jeden Zustand einer jeden Ebene eine Information zugeordnet wird, die für eine durch diesen Zustand laufenden Folge von dekodierten Bits aus der Vergangenheit, im Verhältnis zur Richtung. des Weges durch das Gitter, repräsentativ ist.

**17.** Gemeinschaftliches Dekodierverfahren nach Anspruch 16, **dadurch gekennzeichnet, dass** die erwähnte Information die Position des betrachteten Bits im Baum bezeichnet, der den entropischen Code und/oder eine Information zum Verifizieren der Zahl der dekodierten Wörter und/oder den von den dekodierten Bits angenommenen Wert darstellt.

**18.** Gemeinschaftliches Dekodierverfahren nach Anspruch 17, **dadurch gekennzeichnet, dass** es für jeden Zustand die folgenden Schritte umfasst:

- Hinzufügen der Kanalmetrik und der Quellenmetrik zu den zwei in diesem Zustand ankommenden Zweigen,
- Vergleichen der zwei neuen erhaltenen Metriken und Wahl der schwächsten,
- wenn die die Position angebende Information das Ende eines Wortes angibt, Annehmen, dass der Knoten ein Blatt des Baumes ist, sonst Fortschreiten zum nachfolgenden Knoten im Baum.

**19.** Gemeinschaftliches Dekodierverfahren nach einem der Ansprüche 16 bis 18, **dadurch gekennzeichnet, dass** es ein iteratives Verfahren verwendet.

**20.** Gemeinschaftliches Dekodierverfahren nach Anspruch 19, **dadurch gekennzeichnet, dass** es die folgenden Schritte umfasst:

- erste Kanaldekodierung, die ein Kanaldekodierungsgitter verwendet, bei dem jeder Zustand über eine Information verfügt, welche die Position des betrachteten Bits in dem das erwähnte entropische Code darstellenden Baum bezeichnet;
- zweite Kanaldekodierung, gespeist von der ersten Kanaldekodierung über eine Verschachtelungsvorrichtung, die identisch ist zu der beim Kodieren eingesetzten und welche die erste Kanaldekodierung speist, über eine Entschachtelungsvorrichtung, die zur erwähnten Verschachtelungsvorrichtung symmetrisch ist;
- Quellendekodierung, gespeist von der erwähnten zweiten Kanaldekodierung über die besagte Entschachtelungsvorrichtung.

21. Dekodierverfahren nach Anspruch 20, **dadurch gekennzeichnet, dass** es eine Dekodierung des Typs Turbo-Code verwendet.

22. Gemeinschaftliches Dekodierverfahren nach einem der Ansprüche 10 bis 15 oder 21, **dadurch gekennzeichnet, dass** jede Iteration der erwähnten Dekodierung des Typs Turbo-Code eine Blockmatrix verwendet, welche Zeilen und Spalten aufweist und auf welche eine Zeilendekodierung (bzw. Spaltendekodierung) angewandt wird, gefolgt von einer Spaltendekodierung (bzw. Zeilendekodierung) und, dass man diese a priori Information für die Zeilendekodierung (bzw. Spaltendekodierung) benutzt.

23. Gemeinschaftliches Dekodierverfahren nach Anspruch 22, **dadurch gekennzeichnet, dass** jede Zeile (bzw. Spalte) einem aus k Informationsbits gebildetem Codewort entspricht.

24. Gemeinschaftliches Dekodierverfahren nach einem der Ansprüche 9 bis 23, **dadurch gekennzeichnet, dass** der erwähnte entropische Code ein reversibler Code variabler Länge (RVLC) ist.

25. Gemeinschaftliches Dekodierverfahren nach Anspruch 24, **dadurch gekennzeichnet, dass** das Kanaldekodierungsgitter und das Quellendekodierungsgitter miteinander verkettet werden, wobei die Kanaldekodierung durch eine a priori Information bezüglich der Quelle gesteuert wird.

26. Gemeinschaftliches Dekodierverfahren nach Anspruch 25, **dadurch gekennzeichnet, dass** es einen "list Viterbi" genannten Algorithmus der parallelen oder seriellen Art verwendet, der einem Schritt zum Ersetzen einer von der Kodierung nicht zugelassene Folge durch die am wahrscheinlichsten zugelassenen Folge auf dem Weg durch das Kanaldekodierungsgitter zugeordnet ist.

27. Dekodierverfahren nach Anspruch 25, **dadurch gekennzeichnet, dass** es einen "vom SUBMAP" genannten Algorithmus verwendet, sowohl beim Hinlauf als beim Rücklauf durch das Kanaldekodierungsgitter.

28. Gemeinschaftliches Dekodierverfahren nach einem der Ansprüche 22 bis 27, **dadurch gekennzeichnet, dass** es einen Schritt zum Erfassen des Anfangs und/oder des Endes eines jeden Codewortes umfasst.

29. Gemeinschaftliches Dekodierverfahren nach Anspruch 28, **dadurch gekennzeichnet, dass** der erwähnte Erfassungsschritt auf der Anwendung von mindestens einer der Techniken aus der Gruppe basiert, die folgendes umfasst:

   - Einfügen einer Information bezüglich des Wortanfangs und/oder Wortendes beim Senden;
   - Einfügen von Füllbits, damit die Wörter zusammen mit den Füllbits eine konstante Länge aufweisen;
   - Anwenden der "bit-tailing" genannten Technik,
   - Verwenden eines kreisförmigen Gitters.

30. Dekodierverfahren nach einem der Ansprüche 1 bis 29, **dadurch gekennzeichnet**, das es ferner einen Schritt zum Suchen der mit der höchsten Wahrscheinlichkeit zugelassenen Folge mit Hilfe eines reduzierten Symbolgitters, das einen einzigen Ausgangszustand (d0) aufweist, wobei die Zahl der ein- und ausgehenden Codewörter gleich der Zahl der existierenden Codewörter ist.

31. Verfahren zum Dekodieren von empfangenen Digitaldaten, die gesendeten Digitaldaten entsprechen, welche mittels eines entropischen Codes codiert worden sind, der einem jeden Wort eines Alphabets eine unterschiedliche Bitfolge zuordnet, deren Länge eine Funktion der Auftrittswahrscheinlichkeit dieses Wortes ist, welches das Verfahren nach einem der Ansprüche 1 bis 30 verwendet, **dadurch gekennzeichnet, dass** es über Mittel zum Anwenden eines Dekodierungsgitters verfügt, bei dem jeder Übergang einem binären Wert von 0 oder 1 eines der Bits von einer Bitfolge entspricht, die einem der genannten Wörter entspricht.

32. System zum Senden eines digitalen Signals, **dadurch gekennzeichnet, dass** es beim Senden eine entropische Quellenkodierung und eine Kanalkodierung verwendet, während beim Empfang eine Dekodierung nach einem der Ansprüche 1 bis 30 verwendet wird, **dadurch gekennzeichnet, dass** es Mittel zum Anwenden eines Dekodierungsgitters aufweist, bei dem jeder Übergang einem. binären Wert von 0 oder 1 eines der Bits von einer Bitfolge entspricht, die einem der genannten Wörter entspricht.

**Fig. 1**

Etat d2

Etat d1

S0

1    0

S2

S1

1    0    1    0

S3    S4    S5    S6

Etat d3

c    d

1    0

e

S7    S8

a    b

Etat d0

**Fig. 2**

c

d

e

d0    d0    d0    d0

a

b

etage t-2    etage t-1    etage t

t-3    t-2    t-1    t

temps
binaire

ak=0
ak=1

d0    d0

d2    d2

**Fig. 3**

d1    d1

d3    d3

**Fig. 4**

**Fig. 5**

**Fig. 6**

**Fig. 7**

$$p(a_0) < p(a_1) < p(a_2) < p(a_3)$$

**Fig. 8**

k bits      n-k bits

synchronisation des mots de Huffman    bits de parite

noeuds de l'arbre du code
de Huffman

**Fig. 9**

← bits de parite

110    113

Phase aller(1)

Phase retour (2)

Phase APP (3)

112

111

114

Treillis symbole reduit

**Fig. 10**

sortie_hard    proba

SISO_huff    E*

**Fig. 11**

proba

proba    sortie_hard

Xk
Y1k

DEC 1

SISO_huff

E

E

p(0) et p(1)

DEC 2

120

Treillis symbole
reduit

sortie_hard

Xk   Y2k

sortie_hard

E

**Fig. 12**

p(0) et p (1)

proba

120

Xk
Y1k

DEC 1

E

E

DEC 2

Treillis symbole
reduit

sortie_hard

sortie_hard